# FASCICULE DE BREVET EUROPEEN

(11) **EP 4 120 350 B1**
(45) Date de publication et mention de la délivrance du brevet: **15.05.2024**
(21) Numéro de dépôt: 22020340.0
(22) Date de dépôt: 15.07.2022
(51) Int. Cl.: H10N 60/10, H10N 60/01, H10N 69/00, H01L 23/498, H01L 25/065, H01L 21/48, H01L 23/538

(54) **DISPOSITIF ÉLECTRONIQUE DESTINÉ À CONNECTER UN PREMIER COMPOSANT ÉLECTRONIQUE À UN DEUXIÈME COMPOSANT ÉLECTRONIQUE, SYSTÈME COMPRENANT UN TEL DISPOSITIF ET PROCÉDÉS PERMETTANT D'OBTENIR UN TEL DISPOSITIF**
ELEKTRONISCHE VORRICHTUNG ZUM VERBINDEN EINER ERSTEN ELEKTRONISCHEN KOMPONENTE MIT EINER ZWEITEN ELEKTRONISCHEN KOMPONENTE, SYSTEM MIT EINER SOLCHEN VORRICHTUNG UND VERFAHREN ZUR HERSTELLUNG EINER SOLCHEN VORRICHTUNG
ELECTRONIC DEVICE INTENDED FOR CONNECTING A FIRST ELECTRONIC COMPONENT WITH A SECOND ELECTRONIC COMPONENT, SYSTEM INCLUDING SUCH A DEVICE AND METHODS FOR OBTAINING SUCH A DEVICE

(30) Priorité: 15.07.2021 FR 2107657
(43) Date de publication de la demande: 18.01.2023
(73) Titulaire: Commissariat à l'Energie Atomique et aux Energies Alternatives, 75015 Paris (FR)
(72) Inventeur: Charbonnier, Jean, 38054 Grenoble Cedex 09 (FR); Sauvageot, Jean-Luc, 38054 Grenoble Cedex 09 (FR); Thomas, Candice, 38054 Grenoble Cedex 09 (FR)
(74) Mandataire: Cabinet Camus Lebkiri

(56) Documents cités:
- US-A1- 2014 246 763
- US-A1- 2019 229 094
- US-A1- 2020 106 149

## Description

### DOMAINE TECHNIQUE DE L'INVENTION

Le domaine technique de l'invention est celui des composants micro et nano électroniques et de la manière de les connecter entre eux dans le cadre de domaines d'applications liés à l'informatique quantique, à l'électronique supraconductrice ou encore aux dispositifs aérospatiaux.

La présente invention concerne un dispositif électronique destiné à connecter deux composants électroniques et en particulier un dispositif électronique comprenant au moins une piste conductrice comprenant une pluralité de sections, chaque section formant avec la section précédente et la section suivante une interface de désadaptation acoustique.

### ARRIERE-PLAN TECHNOLOGIQUE DE L'INVENTION

Pour les applications relatives à l'informatique quantique et/ou à l'électronique supraconductrice, les dispositifs micro ou nano électroniques fonctionnent généralement à des très basses températures (de l'ordre de quelques Kelvin (K) voire quelques mK) qui sont obtenues grâce à des cryostats à dilution. La gestion thermique des composants qui composent ces systèmes ou bien encore leur packaging diffèrent complètement de ce qui se fait à température ambiante, c'est-à-dire aux alentours de 300 K. En effet, la conductivité thermique, assurée par les phonons et les électrons à 300 K, est principalement régit par le transport électronique à très basses températures. De manière générale, les dispositifs assurant la connexion entre différents composants à isoler les uns des autres ne tirent pas avantage de cette particularité afin d'isoler thermiquement les différents éléments d'un assemblage.

Une problématique similaire est présente dans les applications spatiales. Les composants assurant la commande et la lecture des télescopes ou satellites d'observation sont placés à proximité de capteurs dont le fonctionnement est impacté par la température. Afin de réduire l'effet de la chaleur sur le fonctionnement des capteurs, il est possible d'avoir recours à de longues limandes afin de connecter les capteurs aux composants chargés de la commande et/ou de la lecture. Cependant, la longueur de ces limandes dégrade le signal mesuré et la compacité de l'ensemble. Des dispositifs et des procédés connus sont décrits par US 2014 / 0246763 A1, US 2019 / 0229094 A1 et US 2020 / 0106149 A1. Aucun de ces documents ne divulgue une disposition des interfaces de désadaptation acoustique ou interfaces Kapitza telle que définie par les revendications indépendantes.

Il existe donc un besoin d'un moyen permettant de connecter électriquement deux composants électroniques (ou plus) tout en limitant le flux de chaleur entre ces composants, c'est-à-dire en augmentant la résistance thermique des moyens de connexion tout en améliorant la compacité de l'ensemble.

### RESUME DE L'INVENTION

L'invention offre une solution aux problèmes évoqués précédemment, en permettant d'obtenir au moins une piste conductrice à forte résistance thermique, cette forte résistance thermique étant obtenue en formant une pluralité d'interfaces de désadaptation acoustique au sein de la piste conductrice.

Un premier aspect de l'invention concerne un dispositif électronique comprenant une première surface et une deuxième surface opposée à la première surface et destiné à connecter un premier composant électronique à un deuxième composant électronique situé sur la première surface au moyen d'au moins une piste conductrice, la piste conductrice comprenant une pluralité de sections disposées les unes à la suite des autres de sorte à former la piste conductrice, chaque section étant constituée d'un matériau supraconducteur choisi de sorte à former avec la section qui la suit, si une telle section existe, et la section qui la précède, si une telle section existe, une interface de désadaptation acoustique (ou interface Kapitza).

Grâce à l'invention, il est possible d'obtenir une piste électronique à faible conductance thermique (ou forte résistance thermique). En effet, au niveau de chaque interface de désadaptation acoustique va se créer une résistance thermique d'interface Kapitza permettant d'obtenir un routage à très faible conductivité thermique. Cette résistance thermique d'interface sera d'autant plus importante que la différence de vitesse du son entre les deux matériaux sera importante. En effet, cette différence de vitesse induit une réflexion très efficace des phonons à l'interface. Or ces phonons sont le principal mode de conduction thermique pour les matériaux supraconducteurs très en dessous de leur transition, (les électrons étant alors très principalement condensés en paires de Cooper et donc ne participant plus au transport thermique). Il est ainsi possible de contrôler la conductance thermique à l'aide de deux paramètres : la nature des matériaux utilisés pour réaliser les interfaces de désadaptation acoustique et le nombre de ces interfaces.

Outre les caractéristiques qui viennent d'être évoquées dans le paragraphe précédent, le dispositif selon un premier aspect de l'invention peut présenter une ou plusieurs caractéristiques complémentaires parmi les suivantes, considérées individuellement ou selon toutes les combinaisons techniquement possibles.

Dans un mode de réalisation, le dispositif comporte une alternance de deux types de couches : une première couche d'un premier matériau diélectrique ayant un premier module de Young, dite couche molle, et une deuxième couche d'un deuxième matériau diélectrique ayant un deuxième module de Young supérieur au premier module de Young, dite couche dure, la piste conductrice étant formée dans l'une des couches molles.

Il est ainsi possible de confiner les phonons dans chaque section de la piste conductrice, limitant ainsi la fuite thermique par le substrat sur/dans lequel est formée la piste conductrice.

Dans un mode de réalisation, la piste conductrice comprend une pluralité de premières sections dans un premier matériau supraconducteur et une pluralité de deuxièmes sections dans un deuxième matériau supraconducteur différent du premier matériau supraconducteur, la piste conductrice étant formée par une alternance de premières sections et de deuxièmes sections.

Dans un mode de réalisation, le couple formé par le premier matériau supraconducteur et le deuxième matériau supraconducteur est choisi parmi les couples suivants :
- le couple dans lequel le premier matériau est le niobium et le deuxième matériau est le nitrure de titane ;
- le couple dans lequel le premier matériau est le nitrure de niobium et le deuxième matériau est le nitrure de titane ;
- le couple dans lequel le premier matériau est le nitrure de niobium et le deuxième matériau est le titanure de niobium.

le couple dans lequel le premier matériau est le triniobium-étain (Nb3Sn) et le deuxième matériau est le nitrure de titane (TiN) (de préférence, les couches en triniobium-étain ont une épaisseur au moins trois fois supérieure aux couches de nitrure de titane de sorte à pouvoir atteindre un fonctionnement jusqu'à 2K)

Dans un mode de réalisation, le dispositif comprend une pluralité de niveaux de routage reliés entre eux par des vias, la piste conductrice étant formée sur une partie au moins de ces niveaux de routage et le matériau utilisé pour les sections d'un niveau de routage donné étant différent du matériau utilisé pour les sections du niveau de routage immédiatement au-dessus et au-dessous, chaque via étant fait dans l'un des matériaux du niveau de routage parmi les deux niveaux de routage qu'il relie.

Dans un mode de réalisation, le dispositif comprend une pluralité de niveaux de routage, les niveaux de routage étant connectés entre eux par des vias, la piste conductrice étant formée sur une partie au moins de ces niveaux de routage, la pluralité de premières sections étant formée dans une partie au moins des niveaux de routage de la pluralité de niveaux de routage, chaque deuxième section formant un via reliant une première section de la pluralité de premières sections d'un niveau de routage à une première section de la pluralité de premières sections d'un niveau de routage situé au-dessus ou au-dessous.

L'utilisation de via permet de réaliser une piste conductrice sur plusieurs niveaux de routage. De plus, il est possible d'obtenir une piste conductrice ayant une forte densité d'interface de désadaptation acoustique puisqu'il est possible de réaliser deux interfaces par via.

Dans un mode de réalisation, le dispositif comporte une alternance de deux types de couche : une première couche d'un premier matériau diélectrique ayant un premier module de Young, dite couche molle, et une deuxième couche d'un deuxième matériau diélectrique ayant un deuxième module de Young supérieur au premier module de Young, dite couche dure, chaque niveau de routage étant réalisé dans une couche dure et chaque via étant réalisé, au moins en partie, dans une couche molle. De préférence, le premier matériau diélectrique est le SiO2 et le deuxième matériau diélectrique est le SiN.

Comme mentionné précédemment, il est ainsi possible de confiner les phonons dans chaque section de la piste conductrice, limitant ainsi la fuite thermique par le substrat sur/dans lequel est formée la piste conductrice.

Dans un mode de réalisation, l'extrémité de chaque via s'étend dans une couche dure de sorte que l'interface entre chaque via et les deux niveaux de routage qu'il relie est formée dans une couche dure.

Dans un mode de réalisation, chaque via est réalisé entièrement dans une couche molle et s'étend sur toute l'épaisseur de ladite couche molle.

Dans un mode de réalisation, les matériaux supraconducteurs ont une température critique supérieure à 2K, de préférence supérieure à 4K.

Dans un mode de réalisation, les matériaux supraconducteurs formant les interfaces de désadaptation acoustique sont choisis de sorte que le ratio de la vitesse du son transversale mesurée à 90% de la température critique du matériau ayant la température critique la plus faible dans les matériaux respectifs est supérieur à 1.5, de préférence supérieur à 2. Un tel choix permet d'optimiser la qualité de l'interface de désadaptation acoustique, en réfléchissant de manière efficace les phonons de faible incidence.

Dans un mode de réalisation, chaque piste conductrice comprend, au moins vingt (20) interfaces de désadaptation acoustique, de préférence au moins cent (100) interfaces de désadaptation acoustique, de préférence mille (1000) interfaces de désadaptation acoustique.

Un deuxième aspect de l'invention concerne un procédé de fabrication d'un dispositif électronique à partir d'un substrat, le procédé comprenant :
- une première étape de dépôt d'une couche d'un premier matériau supraconducteur sur le substrat ;
- une première étape de lithographie de la couche de premier matériau supraconducteur de sorte à définir des motifs sur ladite couche ;
- une première étape de gravure des motifs définis lors de la première étape de lithographie sur toute l'épaisseur de la couche de premier matériau supraconducteur ;
- une deuxième étape de dépôt d'une couche d'un deuxième matériau supraconducteur sur la couche de premier matériau supraconducteur et dans les motifs gravés lors de la première étape de gravure ;
- une deuxième étape de lithographie de la couche de deuxième matériau supraconducteur de sorte à définir des motifs sur la partie de la couche de deuxième matériau supraconducteur située sur la couche de premier matériau supraconducteur ;
- une deuxième étape de gravure des motifs définis lors de la deuxième étape de lithographie sur toute l'épaisseur de la couche de deuxième matériau supraconducteur de sorte à définir une pluralité de sections disposées les unes à la suite des autres pour former au moins une piste conductrice, deux sections successives étant dans un matériau supraconducteur différent et choisi parmi le premier matériau supraconducteur et le deuxième matériau supraconducteur de sorte à former une interface de désadaptation acoustique entre chaque section.

Outre les caractéristiques qui viennent d'être évoquées dans le paragraphe précédent, le procédé selon un deuxième aspect de l'invention peut présenter une ou plusieurs caractéristiques complémentaires parmi les suivantes, considérées individuellement ou selon toutes les combinaisons techniquement possibles.

Dans un mode de réalisation, le procédé comprend en outre, après la deuxième étape de gravure, une étape de dépôt d'une couche d'encapsulation.

Dans un mode de réalisation, le procédé comprend en outre, après la deuxième étape de gravure et avant l'étape de dépôt d'une couche d'encapsulation si cette étape est mise en oeuvre, une étape de polissage mécano-chimique.

Un troisième aspect de l'invention concerne un procédé de fabrication d'un dispositif électronique à partir d'un substrat, le procédé comprenant :
- une première étape de dépôt d'une couche d'un premier matériau supraconducteur sur le substrat ;
- une première étape de lithographie de la couche de premier matériau supraconducteur de sorte à définir des motifs sur ladite couche ;
- une première étape de gravure des motifs définis lors de la première étape de lithographie sur toute l'épaisseur de la couche de premier matériau supraconducteur ;
- une deuxième étape de dépôt d'une couche de passivation sur la couche de premier matériau supraconducteur et sur le substrat encore exposé ;
- une deuxième étape de lithographie de la couche de passivation de sorte à définir des motifs sur ladite couche au-dessus de la couche de premier matériau supraconducteur ;
- une deuxième étape de gravure des motifs définis lors de la deuxième étape de lithographie sur toute l'épaisseur de la couche de passivation de sorte à exposer une partie de la couche d'un premier matériau supraconducteur ;
- une troisième étape de dépôt d'une couche d'un deuxième matériau supraconducteur différent du premier matériau supraconducteur sur la couche de passivation et dans les motifs gravés lors de la deuxième étape de gravure ;
- une étape de polissage mécano-chimique de sorte à ne conserver que la couche d'un deuxième matériau conducteur déposée dans les motifs gravés précédemment et ainsi former des vias dans le deuxième matériau supraconducteur ;
- une quatrième étape de dépôt d'une couche du premier matériau supraconducteur ;
- une troisième étape de lithographie de la couche de premier matériau supraconducteur de sorte à définir des motifs sur ladite couche ;
- une troisième étape de gravure des motifs définis lors de la troisième étape de lithographie sur toute l'épaisseur de la couche de premier matériau supraconducteur.

De plus, dans le procédé selon un troisième aspect de l'invention, le premier matériau supraconducteur et le deuxième matériau supraconducteur sont choisis de sorte à former, lorsqu'ils sont en contact l'un de l'autre, une interface de désadaptation acoustique.

Outre les caractéristiques qui viennent d'être évoquées dans le paragraphe précédent, le procédé selon un troisième aspect de l'invention peut présenter une ou plusieurs caractéristiques complémentaires parmi les suivantes, considérées individuellement ou selon toutes les combinaisons techniquement possibles.

Dans un mode de réalisation, les première, deuxième et troisième étapes de dépôt, les première et deuxième étapes de lithographie, les première et deuxième étapes de gravure et l'étape de polissage mécano chimique sont répétées une pluralité de fois de sorte à obtenir une pluralité de niveaux de routage dans le premier matériau supraconducteur connectés entre eux par des vias dans le deuxième matériau supraconducteur.

Un quatrième aspect de l'invention concerne un procédé de fabrication d'un dispositif à partir d'un substrat comprenant une première couche d'un matériau diélectrique ayant un premier module de Young, dite couche molle, le procédé comprenant :
- une première étape de dépôt d'une deuxième couche d'un deuxième matériau diélectrique, dite couche dure, ayant un deuxième module de Young supérieur au premier module de Young ;
- une deuxième étape de dépôt d'une couche d'un premier matériau supraconducteur sur la couche dure déposée lors de la première étape de dépôt ;
- une première étape de lithographie de sorte à définir les motifs d'une ou plusieurs sections d'une piste conductrice dans la couche de premier matériau supraconducteur ;
- une première étape de gravure de la couche d'un premier matériau supraconducteur sur toute son épaisseur selon les motifs définis lors de la première étape de lithographie ;
- une troisième étape de dépôt d'une couche du deuxième matériau diélectrique de sorte à recouvrir les sections obtenues à l'issue de la première étape de gravure ;
- une première étape de polissage mécano-chimique de la couche du deuxième matériau diélectrique déposée lors de la troisième étape de dépôt ;
- une quatrième étape de dépôt d'une couche de premier matériau diélectrique sur la couche de deuxième matériau diélectrique ;
- une cinquième étape de dépôt d'une couche de deuxième matériau diélectrique sur la couche de premier matériau diélectrique ;
- une deuxième étape de lithographie de sorte à définir les motifs d'une ou plusieurs sections de la piste conductrice destinées à former les vias de la piste conductrice ;
- une deuxième étape de gravure selon les motifs définis lors de la deuxième étape de lithographie jusqu'à découvrir les parties de la couche de matériau supraconducteur situées sous les motifs ;
- une sixième étape de dépôt d'une couche d'un deuxième matériau supraconducteur selon une épaisseur suffisante pour combler les motifs gravés lors de la deuxième étape de gravure ;
- une deuxième étape de polissage mécano-chimique de sorte à retirer le deuxième matériau supraconducteur en dehors des motifs définis lors de la deuxième étape de lithographie et ainsi dégager la couche de deuxième matériau diélectrique déposée lors de la cinquième étape de dépôt ;
- une septième étape de dépôt d'une couche du premier matériau supraconducteur sur la structure issue de l'étape précédente ;
- une troisième étape de lithographie de sorte à définir les motifs d'une ou plusieurs sections de la piste conductrice ;
- une troisième étape de gravure de la couche du premier matériau sur toute son épaisseur selon les motifs définis lors de la troisième étape de lithographie ;
- une huitième étape de dépôt d'une couche du deuxième matériau diélectrique ;
- une troisième étape de polissage mécano-chimique de la couche du deuxième matériau diélectrique déposée lors de la huitième étape de dépôt ;
- une neuvième étape de dépôt d'une couche du premier matériau diélectrique.

De plus, dans le procédé selon un quatrième aspect de l'invention, le premier matériau supraconducteur et le deuxième matériau supraconducteur sont choisis de sorte à former, lorsqu'ils sont en contact l'un de l'autre, une interface de désadaptation acoustique.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre une représentation schématique d'un système selon l'invention dans lequel un dispositif selon l'invention comprend une pluralité de sections différentes.
La [Fig. 2] montre une représentation schématique d'un système selon l'invention dans lequel un dispositif selon l'invention comprend une succession de section dans un premier matériau supraconducteur et dans un deuxième matériau supraconducteur.
La [Fig. 3] montre une représentation schématique d'un dispositif similaire à la celui de la [Fig. 2] mais dans lequel la piste conductrice n'est pas à la surface du dispositif.
La [Fig. 4] montre une représentation schématique d'un dispositif selon l'invention comprenant une pluralité de couches diélectriques dures et de couches diélectriques molles.
La [Fig. 5] montre une représentation schématique d'un dispositif selon l'invention présentant une pluralité de niveaux de routage, lesdits niveaux étant reliés au moyen de vias formés du même matériau supraconducteur que le niveau de routage supérieur ou le niveau de routage inférieur.
La [Fig. 6] montre une représentation schématique d'un dispositif selon l'invention présentant une pluralité de niveaux de routage, lesdits niveaux étant reliés au moyen de vias standards formés d'un matériau supraconducteur différent des niveaux de routage supérieurs et inférieurs.
La [Fig. 7] et la [Fig. 8] montrent une représentation schématique d'un dispositif selon l'invention comprenant une pluralité de couches diélectriques dures et de couches diélectriques molles ainsi qu'une pluralité de niveaux de routage.
La [Fig. 9] montre un logigramme d'un premier procédé de fabrication selon l'invention.
Les [Fig. 10A] à [Fig. 10H] illustre de manière schématique les étapes du premier procédé selon l'invention.
La [Fig. 11] montre un logigramme d'un deuxième procédé de fabrication selon l'invention.
Les [Fig. 12A] à [Fig. 12K] illustre de manière schématique les étapes du deuxième procédé selon l'invention.
La [Fig. 13] montre un logigramme d'un troisième procédé de fabrication selon l'invention.
Les [Fig. 14A] à [Fig. 14I] illustre de manière schématique les étapes du troisième procédé selon l'invention.

### DESCRIPTION DETAILLEE

Les figures sont présentées à titre indicatif et nullement limitatif de l'invention. Sauf précision contraire, un même élément apparaissant sur des figures différentes présente une référence unique.

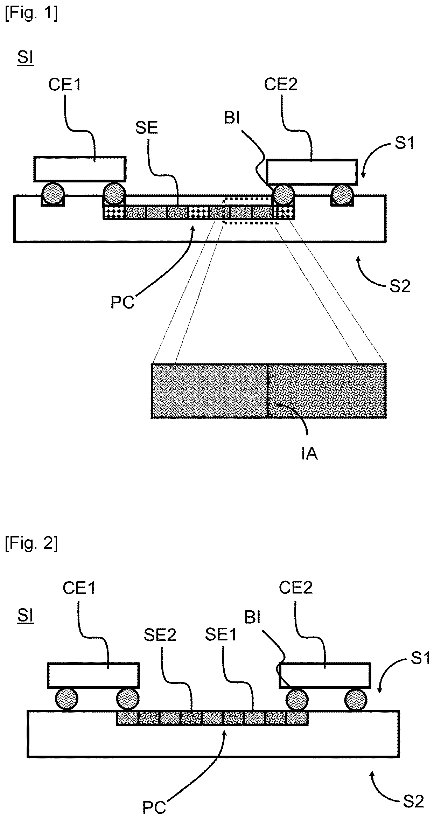

Un premier aspect de l'invention illustré à la [Fig. 1] concerne un dispositif électronique DI, par exemple intégré au sein d'un système SI selon l'invention, comprenant une première surface S1 et une deuxième surface S2 opposée à la première surface S1. Le dispositif DI selon l'invention est destiné à connecter un premier composant électronique CE1 situé sur la première surface S1 à un deuxième composant électronique CE2 également situé sur la première surface S1 au moyen d'au moins une piste conductrice PC de sorte à former un système SI selon l'invention. De plus, la piste conductrice PC comprend une pluralité de sections SE disposées les unes à la suite des autres de sorte à former la piste conductrice PC, chaque section SE étant constituée d'un matériau supraconducteur choisi de sorte à former avec la section SE qui la suit, si une telle section SE existe, et la section SE qui la précède, si une telle section SE existe, une interface de désadaptation acoustique IA ou interface Kapitza.

Dans un mode de réalisation illustré à la [Fig. 2], la piste conductrice PC comprend une pluralité de premières sections SE1 dans un premier matériau supraconducteur et une pluralité de deuxièmes sections SE2 dans un deuxième matériau supraconducteur différent du premier matériau supraconducteur, la piste conductrice PC étant formée par une alternance de premières sections SE1 et de deuxièmes sections SE2. Dans un mode de réalisation, les matériaux formant les interfaces de Kapitza sont choisis de sorte que le ratio de la vitesse du son entre la vitesse du son transversale mesurée à 90% de la température critique du matériau ayant la température critique la plus faible dans les matériaux respectifs est est supérieur à 1.5, de préférence supérieur à 2. Dans un mode particulier de réalisation, le premier matériau est le niobium et le deuxième matériau est le nitrure de titane. De manière plus générale les couples de matériaux supraconducteurs peuvent être composés de nitrure de niobium et de nitrure de titane, de nitrure de niobium et de titanure de niobium, mais d'autres matériaux peuvent être utilisés (par exemple Nb3Ge, Nb3Sn, La3ln, Mg2 ou bien encore YBaCuO).

Dans un mode de réalisation, la projection de la piste conductrice PC sur la première surface S1 du dispositif DI correspond à une droite. Dans un mode de réalisation alternatif, la projection de la piste conductrice PC sur la première surface S1 du dispositif DI correspond à un ensemble de lignes brisées, décrivant par exemple des serpentins ou zig-zags.

Dans un mode de réalisation, la piste conductrice PC est réalisée dans un plan (par opposition à l'utilisation de niveaux de routage décrite plus loin) parallèle à la première surface S1 et proche de cette dernière (on entend par un plan proche de la première surface S1 un plan plus proche de la première surface S1 que de la deuxième surface S2). Un tel mode de réalisation a pour avantage d'éloigner la piste conductrice PC du substrat sur lequel la piste conductrice PC est réalisée et donc de limiter les fuites thermiques. Dans un mode particulier de réalisation illustré à la [Fig. 2], la piste conductrice est réalisée au niveau de la première surface S1.

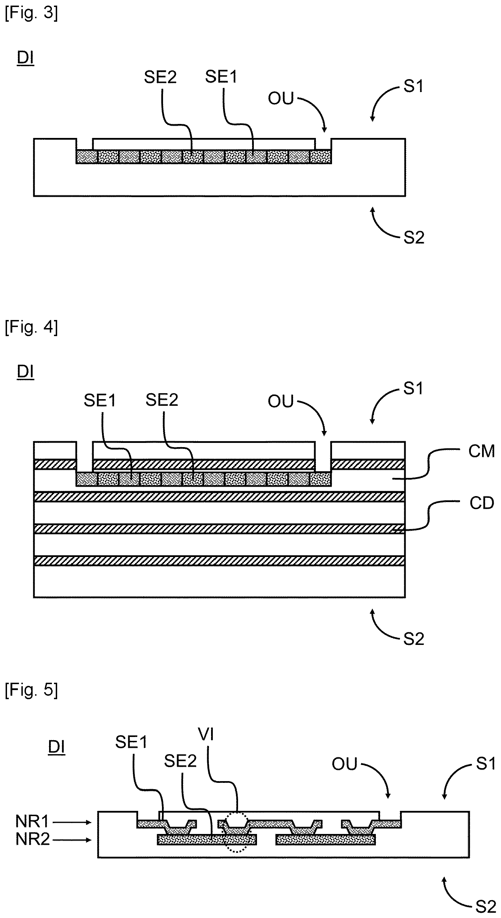

Dans un autre mode de réalisation illustré à la [Fig. 3] (sur cette figure et les suivantes, les composants CE1, CE2 à relier ne sont plus représentés), la piste conductrice PC est recouverte d'une ou plusieurs couches de matériaux diélectriques, lesdites couches séparant la piste conductrice PC de la première surface S1. Bien entendu, dans ce cas, des ouvertures OU sont aménagées au-dessus de la piste conductrice PC pour permettre la reprise de contact via la surface S1, par exemple au moyen d'une métallisation sous bille (ou UBM pour Under Bump Metallisation en anglais) et d'une bille BI (cf. [Fig. 1] et [Fig. 2]). La métallisation sous bille peut être en nitrure de titane ou bien encore comprendre une couche de titane, une couche de platine sur la couche de titane et une couche d'or sur la couche de platine (autrement dit, un empilement Ti/Pt/Au), de préférence comprendre une couche de titane, une couche de nitrure de tungstène sur la couche de titane et une couche d'or sur la couche de nitrure de tungstène (autrement dit, un empilement Ti/WN/Au - Cet empilement permet notamment d'obtenir une bonne adhérence). Les billes BI peuvent être en indium, en alliage à base d'indium ou encore en alliage étain-argent.

Dans un mode de réalisation illustré à la [Fig. 4], le dispositif électronique DI comporte une alternance de deux couches diélectriques différentes : une première couche d'un premier matériau diélectrique avec un premier module de Young, dite couche molle CM, et une deuxième couche d'un deuxième matériau diélectrique avec un deuxième module de Young, supérieur au premier module de Young, dite couche dure CD. Dans un mode de réalisation, l'épaisseur de chaque couche diélectrique de cette alternance est comprise entre 10 nm et 2µm, de préférence comprise entre 50 nm et 600nm. De plus, la piste conductrice PC est formée dans une couche molle CM située proche de la première surface S1. La réalisation de la piste conductrice PC dans une couche molle CM permet de réduire encore les fuites thermiques, une interface supplémentaire de désadaptation acoustique se formant entre une partie au moins des sections SE1,SE2 formant la piste conductrice PC et la couche molle CM dans laquelle est réalisée la piste conductrice PC.

Dans un mode de réalisation alternatif aux précédents illustré à la [Fig. 5], le dispositif électronique DI comprend une pluralité de niveaux de routage NR reliés entre eux par des vias VI, la piste conductrice PC étant formée sur une partie au moins de ces niveaux de routage NR et le matériau utilisé pour les sections SE d'un niveau de routage NR donné étant différent du matériau utilisé pour les sections SE du niveau de routage NR immédiatement au-dessus et au-dessous, chaque via VI étant fait dans l'un des matériaux du niveau de routage NR parmi les deux niveaux de routage NR qu'il relie. Dans l'exemple de la [Fig. 5], deux niveaux de routage reliés par ce type de vias simplifiés ont été utilisés. Cependant, des vias VI standards aux dimensions plus faibles et/ou un plus grand nombre de niveaux de routage NR peuvent également être utilisés. Dans ce mode de réalisation, de préférence, le ratio largeur/épaisseur des vias VI est compris entre 3 et 5. Par exemple, pour une épaisseur (c'est-à-dire la hauteur des vias) comprise entre 50 et 600nm, la largeur des vias VI sera comprise entre 150 nm et 3 µm.

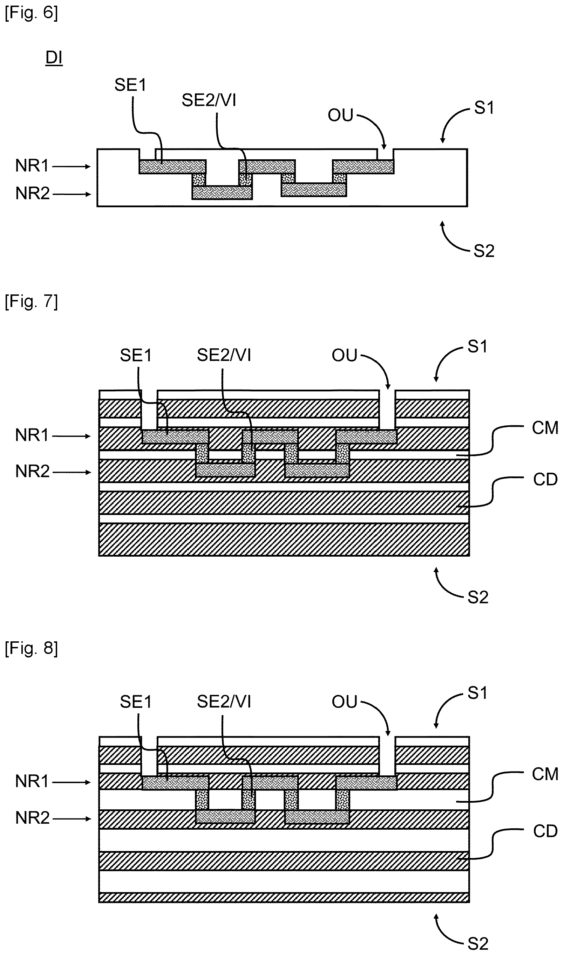

Dans un autre mode de réalisation alternatif illustré à la [Fig. 6], le dispositif DI comprend une pluralité de niveaux de routage NR, les niveaux de routage NR étant connectés entre eux par des vias VI, la piste conductrice PC étant formée sur une partie au moins de ces niveaux de routage NR, la pluralité de premières sections SE1 formant une partie au moins des niveaux de routage NR de la pluralité de niveaux de routage, chaque deuxième section SE2 formant un via VI reliant une première section SE1 de la pluralité de premières sections SE1 d'un niveau de routage NR1 à une première section SE1 de la pluralité de premières sections SE1 d'un niveau de routage NR2 situé au-dessus ou au-dessous. Dans l'exemple de la [Fig. 6], deux niveaux de routage NR1, NR2 reliés par des vias VI ont été utilisés. Cependant, un plus grand nombre de niveaux de routage NR1, NR2 peuvent également être utilisés. Ce mode de réalisation permet d'obtenir une meilleure densité d'interfaces, deux interfaces étant présentes au niveau de chaque via VI. Par ailleurs, un procédé damascène peut être utilisé pour réaliser les vias VI. Dans ce mode de réalisation, de préférence, le ratio largeur/épaisseur des vias VI est compris entre 0.5 et 2. Par exemple, pour une épaisseur (c'est-à-dire la hauteur des vias) comprise entre 50 et 600 nm, la largeur des vias VI sera comprise entre 25 nm et 1200 nm.

Dans un mode de réalisation illustré à la [Fig. 6], lorsque des vias VI sont utilisés pour former la piste conductrice PC, ces derniers sont réalisés en nitrure de titane (TiN) ou en nitrure de tantale (TaN). De manière plus générale, les matériaux supraconducteurs utilisés pour la formation de la piste conductrice PC sont préférentiellement des matériaux compatibles avec des procédés d'intégration de type damascène, des procédés de gravure ou des procédés de polissage mécano-chimique.

Dans un mode de réalisation, le premier et le deuxième matériau supraconducteur sont choisis parmi les matériaux suivant : le Niobium (Nb), le Nitrure de Niobium (NbN), le Nitrure de Tantale (TaN), le Tantale (Ta), le Vanadium (V), l'Alumine de Niobium (Nb3Al), un alliage Titane-Niobium (NbTi) ou bien encore du Vanadium Silicium (V3Si), cette liste étant non exhaustive. Bien entendu, les matériaux sont choisis dans cette liste de sorte à pouvoir former une interface de Kapitza. Dans un mode de réalisation, les matériaux supraconducteurs ont une température critique supérieure à 2K, de préférence supérieure à 4K.

Dans un mode de réalisation, afin d'obtenir une interface de Kapitza de bonne qualité, les matériaux formant les interfaces de Kapitza sont choisis de sorte que le ratio de la vitesse du son dans les matériaux respectifs est supérieur à 1.5, de préférence supérieur à 2, ce ratio étant calculé en calculant le rapport entre la vitesse du son la plus grande et la vitesse du son la plus lente. De tels ratios pourront notamment être obtenus par des interfaces TiN/NbN (ratio égal à 1.6) ou bien encore TiN/Nb (ratio égal à 2.5).

Dans un mode de réalisation, le dispositif DI comporte une alternance de deux couches diélectriques différentes : une première couche d'un premier matériau diélectrique ayant un premier module de Young, dite couche mole CM, et une couche d'un deuxième matériau diélectrique ayant un deuxième module de Young supérieur au premier module de Young, dite couche dure CD. De plus, chaque niveau de routages NR1, NR2 est réalisée dans une couche dure CD, chaque via étant réalisé, au moins en partie, dans une couche mole CM.

Dans un mode de réalisation illustré à la [Fig. 7], l'extrémité de chaque via VI s'étend dans une couche dure CD de sorte que les interfaces entre chaque via VI et les sections SE de la piste conductrice PC situées dans deux niveaux de routage NR1, NR2 qu'il relie sont formées dans une couche dure CD. Ainsi, dans ce mode de réalisation, les sections SE de la piste conductrice PC situées dans deux niveaux de routage NR1, NR2 sont encapsulée par la couche dure CD.

Dans un mode de réalisation alternatif illustré à la [Fig. 8], chaque via VI est réalisé entièrement dans une couche molle CM et s'étend sur toute l'épaisseur de ladite couche molle CM. Autrement dit, les interfaces entre chaque via VI et les sections SE de la piste conductrice PC situées dans deux niveaux de routage NR1, NR2 qu'il relie sont situées au niveau de l'interface entre la couche molle CM dans laquelle est formé le via VI et les couches dures CD dans lesquelles sont formées les sections SE que relie le via VI. Ce mode de réalisation présente l'avantage d'être plus facile à mettre en oeuvre que le mode de réalisation précédent.

Dans un mode de réalisation, les vias VI ont une hauteur comprise entre 50 et 600 nm. Dans un mode de réalisation, les sections SE1, SE2 hors vias VI ont une hauteur comprise entre 5 nm et 1 µm, de préférence entre 50 et 300 nm.

Dans un mode de réalisation, la couche molle est en oxyde de silicium (SiO2) et la couche dure est en nitrure de silicium (Si3N4). De plus, les vias sont en nitrure de titane (TiN) et les sections de piste conductrice formées dans les couches molles sont en niobium (Nb).

### Fabrication

### Premier procédé 100

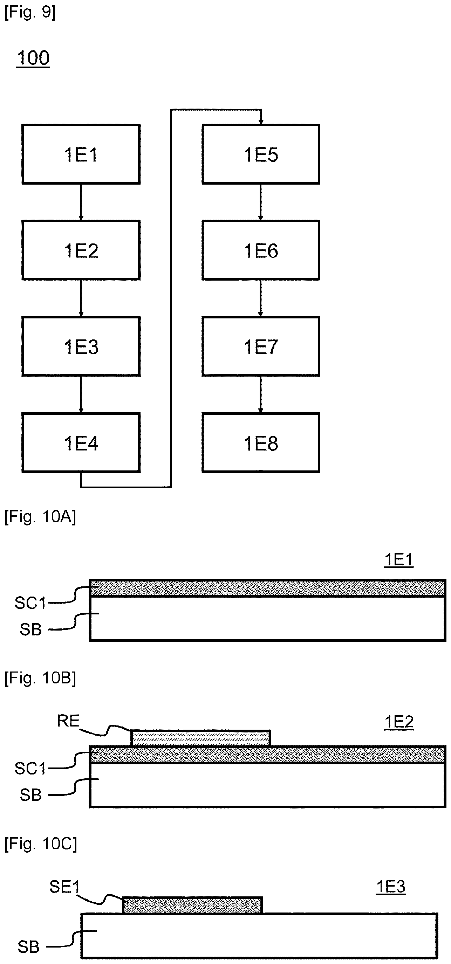

Un deuxième aspect de l'invention illustré à la [Fig.9] concerne un procédé 100 de fabrication d'un dispositif électronique DI à partir d'un substrat SB. De préférence, ce substrat SB comprend une couche de silicium et une couche d'oxyde de silicium sur la couche de silicium.

Comme illustré à la [Fig. 10A], le procédé 100 comprend une première étape 1E1 de dépôt d'une couche d'un premier matériau supraconducteur SC1 sur le substrat SB. Dans un mode de réalisation, le premier matériau supraconducteur est le Niobium.

Comme illustré à la [Fig. 10B], le procédé 100 comprend ensuite une première étape 1E2 de lithographie de la couche de premier matériau supraconducteur de sorte à définir des motifs sur ladite couche, par exemple à l'aide d'une résine développée RE.

Comme illustré à la [Fig. 10C], le procédé 100 comprend ensuite une première étape 1E3 de gravure des motifs définis lors de la première étape 1E2 de lithographie sur toute l'épaisseur de la couche SC1 de premier matériau supraconducteur. Ainsi, les premières sections SE1 dans le premier matériau supraconducteur sont obtenues à la surface du substrat SB.

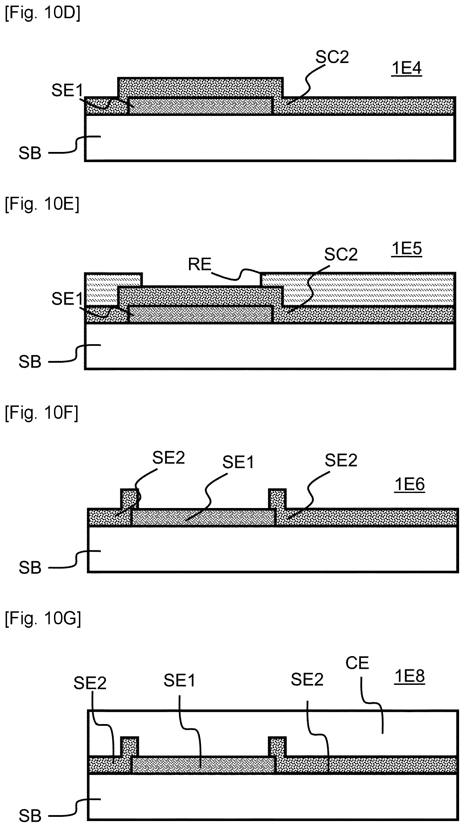

Comme illustré à la [Fig. 10D], le procédé 100 comprend ensuite une deuxième étape 1E4 de dépôt d'une couche d'un deuxième matériau supraconducteur SC2 sur la couche de premier matériau supraconducteur SE1 et dans les motifs gravés lors de la première étape 1E3 de gravure, par exemple à l'aide d'une résine RE. Dans un mode de réalisation, le deuxième matériau supraconducteur est le nitrure de titane.

Comme illustré à la [Fig. 10E], le procédé 100 comprend ensuite une deuxième étape 1E5 de lithographie de la couche de deuxième matériau supraconducteur SC2 de sorte à définir des motifs sur la partie de la couche de deuxième matériau supraconducteur SC2 située sur les premières sections du premier matériau supraconducteur SE1.

Comme illustré à la [Fig. 10F], le procédé 100 comprend ensuite une deuxième étape 1E6 de gravure des motifs définis lors de l'étape précédente sur toute l'épaisseur de la couche du deuxième matériau supraconducteur SC2 de sorte à définir une pluralité de sections SE1, SE2 disposées les unes à la suite des autres pour former au moins une piste conductrice PC, deux sections SE1, SE2 successives étant dans un matériau supraconducteur différent et choisi parmi le premier matériau supraconducteur SC1 et le deuxième matériau supraconducteur SC2 de sorte à former entre eux une interface de désadaptation acoustique IA. Dans un mode de réalisation, le motif de gravure est choisi de sorte que, à l'issue de la deuxième étape 1E6 de gravure, le recouvrement entre la couche du premier matériau supraconducteur SC1 et la couche du deuxième matériau supraconducteur SC2 est supérieur à l'overlay de l'équipement de lithographie utilisé (avantageusement 1,5 fois l'overlay de l'équipement lithographique utilisé), par exemple supérieur à 50 nm pour les Steppers, ou supérieur à 3µm pour les « Mask Aligner ».

Dans un mode de réalisation illustré à la [Fig. 10G], le procédé 100 comprend en outre, après la deuxième étape 1E6 de gravure, une étape 1E8 de dépôt d'une couche d'encapsulation CE. Dans un mode de réalisation, la couche d'encapsulation CE est une couche d'un matériau diélectrique. Dans un mode de réalisation alternatif, la couche d'encapsulation CE comporte une pluralité de couches de matériaux diélectriques. Dans ce cas, des ouvertures OU seront ensuite aménagées dans la couche d'encapsulation CE de sorte à permettre la connexion des composants électroniques CE1,CE2 à la piste conductrice PC.

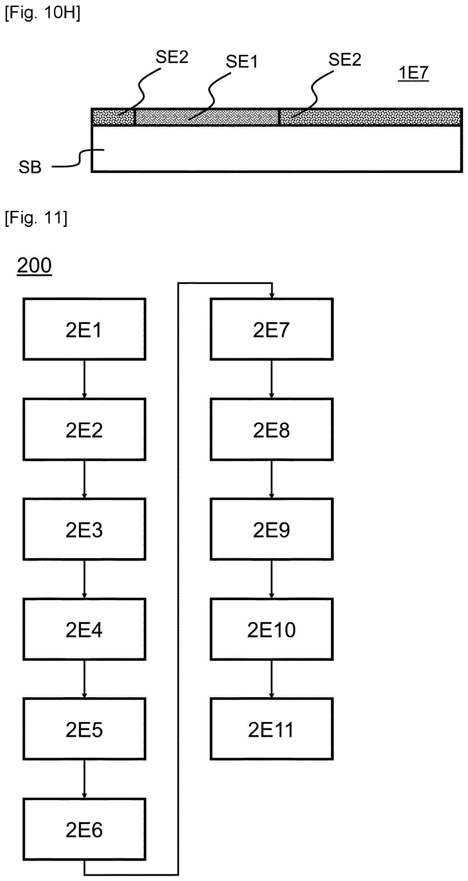

Dans un mode de réalisation illustré à la [Fig. 10H], le procédé 100 comprend également, après la deuxième étape 1E6 de gravure et avant l'étape 1E8 de dépôt d'une couche d'encapsulation CE si cette étape 1E8 est mise en oeuvre, une étape 1E7 de polissage mécano-chimique.

### Deuxième procédé 200

Un troisième aspect de l'invention illustré à la [Fig. 11] concerne un procédé 200 de fabrication d'un dispositif DI à partir d'un substrat SB. De préférence, ce substrat SB comprend une couche de silicium et une couche d'oxyde de silicium sur la couche de silicium.

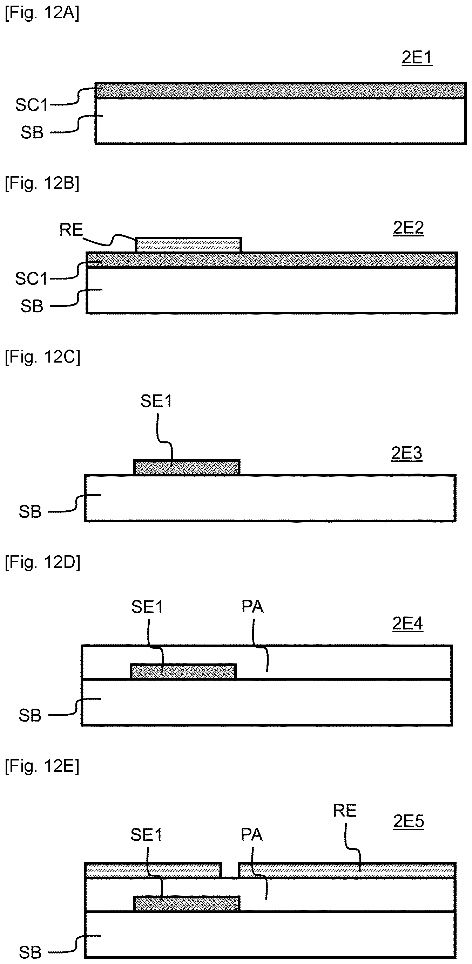

Comme illustré à la [Fig. 12A], le procédé 200 comprend une première étape 2E1 de dépôt d'une couche d'un premier matériau supraconducteur SC1 sur le substrat SB. Dans un mode de réalisation, le premier matériau supraconducteur est le Niobium.

Comme illustré à la [Fig. 12B], le procédé 200 comprend également une première étape 2E2 de lithographie de la couche de premier matériau supraconducteur SC1 de sorte à définir des motifs sur ladite couche, par exemple à l'aide d'une résine développée RE.

Comme illustré à la [Fig. 12C], le procédé 200 comprend également une première étape 2E3 de gravure des motifs définis lors de la première étape 2E2 de lithographie sur toute l'épaisseur de la couche de premier matériau SC1 supraconducteur.

Comme illustré à la [Fig. 12D], le procédé 200 comprend également une deuxième étape 2E4 de dépôt d'une couche de passivation PA sur la couche de premier matériau supraconducteur SE1 et sur le substrat SB encore exposé. Dans un mode de réalisation, cette couche de passivation PA est une couche d'un matériau diélectrique mou ou dur telle que décrite précédemment.

Comme illustré à la [Fig. 12E], le procédé 200 comprend également une deuxième étape 2E5 de lithographie de la couche de passivation PA de sorte à définir des motifs sur ladite couche PA au-dessus de la couche SE1 de premier matériau supraconducteur, par exemple à l'aide d'une résine développée RE.

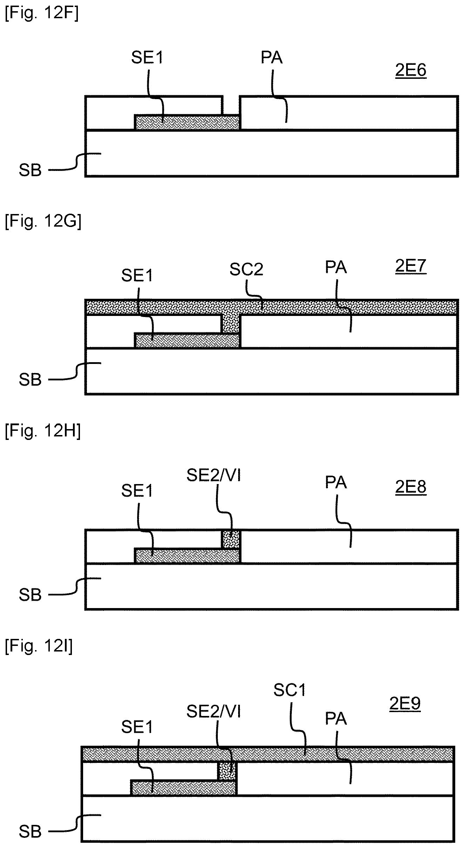

Comme illustré à la [Fig. 12F], le procédé 200 comprend également une deuxième étape 2E6 de gravure des motifs définis lors de la deuxième étape 2E4 de lithographie sur toute l'épaisseur de la couche de passivation PA de sorte à exposer une partie de la couche SC1 d'un premier matériau supraconducteur.

Comme illustré à la [Fig. 12G], le procédé 200 comprend également une troisième étape 2E7 de dépôt d'une couche d'un deuxième matériau supraconducteur SC2 différent du premier matériau supraconducteur SC1 sur la couche de passivation PA et dans les motifs gravés lors de la deuxième étape 2E5 de gravure. Dans un mode de réalisation, le deuxième matériau supraconducteur est le nitrure de titane.

Comme illustré à la [Fig. 12H], le procédé 200 comprend également une étape 2E8 de polissage mécano-chimique de sorte à ne conserver la couche d'un deuxième matériau supraconducteur déposée que dans les motifs gravés précédemment SE2/VI et ainsi former des vias VI dans le deuxième matériau supraconducteur.

Comme illustré à la [Fig. 12I], le procédé 200 comprend une quatrième étape 2E9 de dépôt d'une couche du premier matériau supraconducteur SC1 sur la structure issue des étapes précédentes.

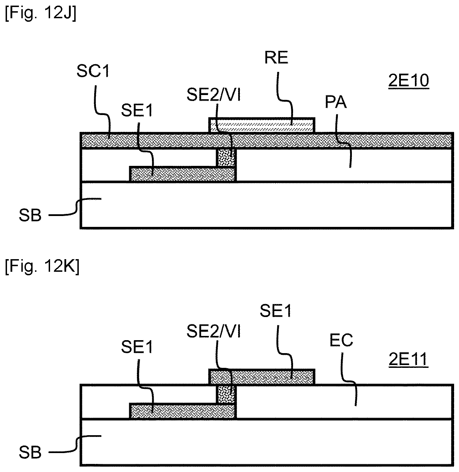

Comme illustré à la [Fig. 12J], le procédé 200 comprend une troisième étape 2E10 de lithographie de la couche de premier matériau supraconducteur SC1 de sorte à définir des motifs sur ladite couche, par exemple à l'aide d'une résine développée RE.

Comme illustré à la [Fig. 12K], le procédé comprend une troisième étape 2E11 de gravure des motifs définis lors de la troisième étape 2E10 de lithographie sur toute l'épaisseur de la couche de premier matériau supraconducteur SE1.

On obtient ainsi une structure à deux niveaux de routage NR1, NR2. Il peut cependant être avantageux d'opérer sur un nombre plus important de niveaux de routage NR. Pour cela, dans un mode de réalisation, les étapes précédentes 2E1-2E8 sont répétées une pluralité de fois de sorte à obtenir une pluralité de niveaux de routage dans le premier matériau supraconducteur connectés entre eux par des vias VI dans le deuxième matériau supraconducteur.

### Troisième procédé 300

Un quatrième aspect de l'invention concerne un procédé de fabrication d'un dispositif DI à partir d'un substrat SB comprenant une première couche d'un matériau diélectrique ayant un premier module de Young, dite couche molle CM. De préférence, ce substrat SB comprend une couche de silicium et une couche d'oxyde de silicium sur la couche de silicium et la couche molle du substrat est constituée par la couche de SiO2.

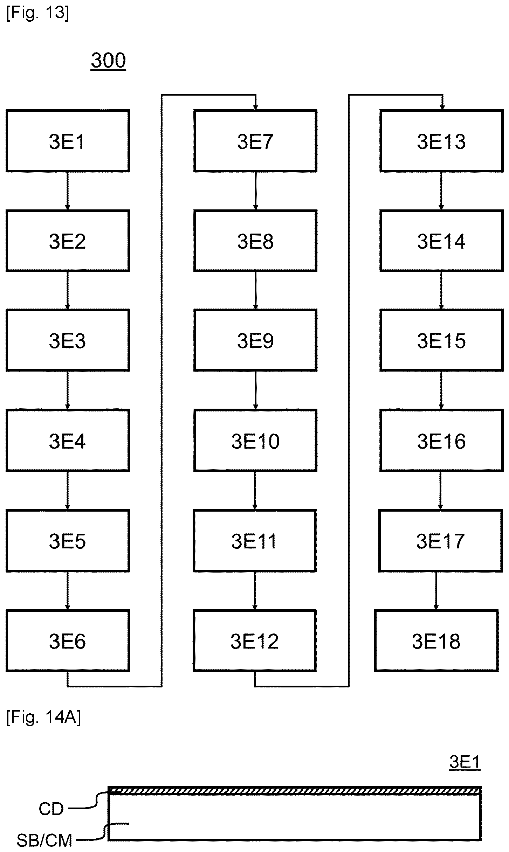

Comme illustré à la [Fig. 14A], le procédé 300 comprend une première étape 3E1 de dépôt d'une deuxième couche CD d'un deuxième matériau diélectrique, dite couche dure CD, ayant un deuxième module de Young supérieur au premier module de Young. Dans un mode de réalisation, l'épaisseur déposée est comprise entre 40 nm et 60 nm, de préférence égale à 50 nm.

Le procédé comprend également une deuxième étape 3E2 de dépôt d'une couche d'un premier matériau supraconducteur SC1 sur la couche CD dure déposée lors de la première étape 3E1 de dépôt. Dans un mode de réalisation, l'épaisseur déposée est comprise entre 5 nm et 1 µm.

Le procédé 300 comprend ensuite une première étape 3E3 de lithographie de sorte à définir les motifs d'une ou plusieurs sections d'une piste conductrice dans la couche de premier matériau supraconducteur.

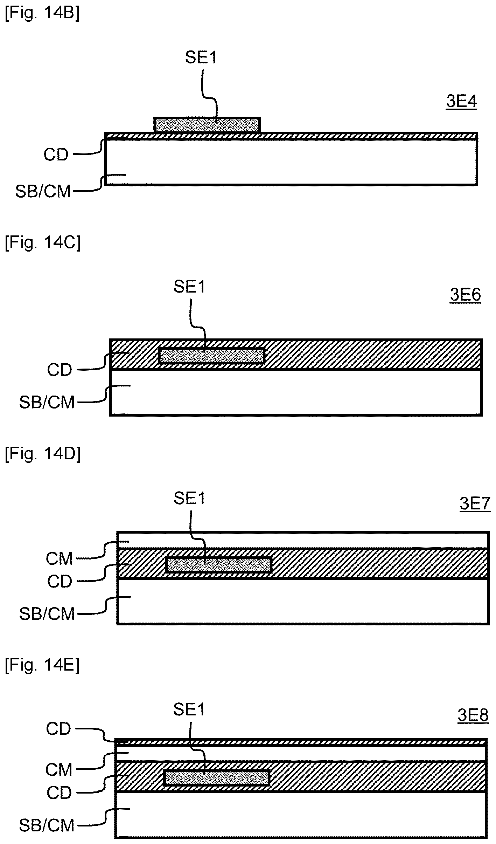

Comme illustré à la [Fig. 14B], le procédé 300 comprend ensuite une première étape 3E4 de gravure de la couche d'un premier matériau supraconducteur sur toute son épaisseur selon les motifs définis lors de la première étape 3E3 de lithographie.

Le procédé comprend également une troisième étape 3E5 de dépôt d'une couche CD du deuxième matériau diélectrique de sorte à recouvrir les sections SE1 obtenues à l'issue de la première étape 3E4 de gravure.

Comme illustré à la [Fig. 14C], cette étape 3E5 est suivie d'une première étape 3E6 de polissage mécano-chimique de la couche CD du deuxième matériau diélectrique déposée lors de la troisième étape 3E5 de dépôt. Dans un mode de réalisation, le polissage mécano-chimique est réalisé de sorte que l'épaisseur de la couche CD du deuxième matériau diélectrique au-dessus des sections SE1 obtenues à l'issue de la première étape 3E4 de gravure est comprise entre 40 nm et 60 nm, de préférence égale à 50 nm.

Comme illustré à la [Fig. 14D], le procédé 300 comprend en outre une quatrième étape 3E7 de dépôt d'une couche CM de premier matériau diélectrique sur la couche CD de deuxième matériau diélectrique. Dans un mode de réalisation, l'épaisseur déposée est comprise entre 50 nm et 500 nm. Comme illustré à la [Fig. 14E], cette étape 3E7 est suivie d'une cinquième étape 3E8 de dépôt d'une couche CD de deuxième matériau diélectrique sur la couche CM de premier matériau diélectrique. Dans un mode de réalisation, l'épaisseur déposée est comprise entre 40 nm et 60 nm, de préférence égale à 50 nm.

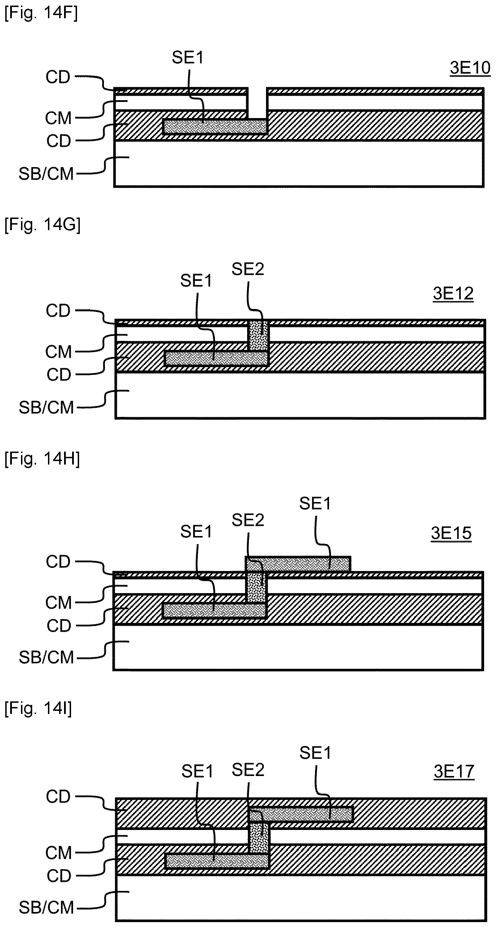

Le procédé 300 comprend ensuite une deuxième étape 3E9 de lithographie de sorte à définir les motifs d'une ou plusieurs sections SE2 de la piste conductrice PC destinées à former les vias VI de la piste conductrice PC, puis, comme illustré à la [Fig. 14F], une deuxième étape 3E10 de gravure selon les motifs définis lors de la deuxième étape de lithographie 3E9 jusqu'à découvrir les parties de la couche de matériau supraconducteur SE1 situées sous les motifs.

Le procédé comprend également une sixième étape 3E11 de dépôt d'une couche d'un deuxième matériau supraconducteur SC2 selon une épaisseur suffisante pour combler les motifs gravés lors de la deuxième étape 3E10 de gravure. Comme illustré à la [Fig. 14G], cette étape 3E11 est suivie une deuxième étape 3E12 de polissage mécano-chimique de sorte à retirer le deuxième matériau supraconducteur en dehors des motifs définis lors de la deuxième étape 3E9 de lithographie et ainsi dégager la couche CD de deuxième matériau diélectrique déposée lors de la cinquième étape de dépôt 3E8.

Le procédé comprend en outre une septième étape 3E13 de dépôt d'une couche du premier matériau supraconducteur sur la structure issue de l'étape 3E12 précédente. Dans un mode de réalisation, l'épaisseur déposée est comprise entre 50 nm et 300 nm. Cette étape 3E13 est suivie d'une troisième étape 3E14 de lithographie de sorte à définir les motifs d'une ou plusieurs sections SE1 de la piste conductrice PC.

Comme illustré à la [Fig. 14H], le procédé 300 comprend ensuite une troisième étape 3E15 de gravure de la couche SC1 du premier matériau sur toute son épaisseur selon les motifs définis lors de la troisième étape 3E14 de lithographie.

Le procédé 300 comprend également une huitième étape 3E16 de dépôt d'une couche CD du deuxième matériau diélectrique suivie, comme illustré à la [Fig. 14I], d'une troisième étape 3E17 de polissage mécano-chimique de la couche CD du deuxième matériau diélectrique déposée lors de la huitième étape 3E16 de dépôt. Dans un mode de réalisation, le polissage mécano-chimique est réalisé de sorte que l'épaisseur de la couche CD du deuxième matériau diélectrique au-dessus des sections SE1 obtenues à l'issue de la première étape 3E15 de gravure est comprise entre 40 nm et 60 nm, de préférence égale à 50 nm.

Le procédé 300 comprend enfin une neuvième étape 3E18 de dépôt d'une couche CM du premier matériau diélectrique.

### Considérations communes

Les choix préférentiels dans les matériaux supraconducteurs faits dans la partie relative au dispositif s'appliquent également aux procédés qui viennent d'être décrits.

Dans un mode de réalisation, les étapes de dépôt des matériaux supraconducteurs sont réalisées par évaporation, CVD (Chemical Vapor Déposition) ou PVD (Physical Vapor Déposition). Dans un mode de réalisation, l'épaisseur de la couche d'un premier matériau supraconducteur et/ou d'un deuxième matériau conducteur est comprise entre 5 nm et 1 µm, par exemple égale à 200nm.

Dans un mode de réalisation, à l'issue du procédé, les premières et deuxièmes sections ont une largeur comprise entre 50 nm et 500 µm, par exemple égale à 1 µm. On entend par largeur d'une section, la dimension la plus faible de la section considérée dans le plan défini par le substrat.

Dans un mode de réalisation, la piste conductrice formée à l'issue du procédé comprend au moins dix (10) sections, de préférence cent (100) sections, voire mille (1000) sections. Dans un mode de réalisation, le nombre de section de la piste conductrice est égale à cent (100).

Dans un mode de réalisation, le procédé comprend une étape de fabrication d'une métallisation sous bille et d'une bille BI. Dans un mode de réalisation, cette métallisation sous bille -est en nitrure de titane. Dans un autre mode de réalisation, cette métallisation comprend une couche de titane, une couche de platine sur la couche de titane et une couche d'or sur la couche de platine (autrement dit, un empilement Ti/Pt/Au). Dans un autre mode de réalisation, cette métallisation comprend une couche de titane, une couche de nitrure de tungstène sur la couche de titane et une couche d'or sur la couche de nitrure de tungstène (autrement dit, un empilement Ti/WN/Au - Cet empilement permet notamment d'obtenir une bonne adhérence). Les billes BI peuvent être en indium, en alliage à base d'indium ou encore en alliage étain-argent.

Le procédé comprend également, à l'issue de l'étape de fabrication d'une métallisation sous bille et du billage du dispositif DI ou des composants électroniques, une étape de report d'un premier composant électronique CE1 et d'un deuxième composant électronique CE2 sur la métallisation sous bille de sorte à obtenir une système comprenant un dispositif DI selon un premier aspect de l'invention, un premier composant électronique CE1 et un deuxième composant électronique CE2, le premier composant électronique CE1 et le deuxième composant électronique CE2 étant disposé sur la première surface S1 du dispositif DI et connectés électriquement l'un à l'autre au moyen de la piste conductrice PC du dispositif DI.

## Revendications

1. Dispositif électronique (DI) comprenant une première surface (S1) et une deuxième surface (S2) opposée à la première surface (S1) et destiné à connecter un premier composant électronique (CE1) à un deuxième composant électronique (CE2) situés sur la première surface (S1) au moyen d'au moins une piste conductrice (PC), la piste conductrice (PC) comprenant une pluralité de premières sections (SE1) dans un premier matériau supraconducteur et une pluralité de deuxièmes sections (SE2) dans un deuxième matériau supraconducteur différent du premier matériau supraconducteur, la piste conductrice (PC) étant formée par une alternance de premières sections (SE1) et de deuxièmes sections (SE2), le premier matériau et le deuxième matériau étant choisis de sorte que chaque section (SE1/SE2) forme avec la section (SE2/SE1) qui la suit, si une telle section (SE2/SE1) existe, et la section (SE2/SE1) qui la précède, si une telle section (SE2/SE1) existe, une interface de désadaptation acoustique (IA).

2. Dispositif (DI) selon la revendication 1, dans lequel le dispositif (DI) comporte une alternance de deux types de couches : une première couche d'un premier matériau diélectrique ayant un premier module de Young, dite couche molle (CM), et une deuxième couche (CD) d'un deuxième matériau diélectrique ayant un deuxième module de Young supérieur au premier module de Young, dite couche dure (CD), la piste conductrice (PC) étant formée dans l'une des couches molles (CM).

3. Dispositif électronique (DI) selon la revendication 1 ou la revendication 2 précédente dans lequel le couple formé par le premier matériau supraconducteur et le deuxième matériau supraconducteur est choisi parmi les couples suivants :
- Le couple dans lequel le premier matériau est le niobium et le deuxième matériau est le nitrure de titane ;
- Le couple dans lequel le premier matériau est le nitrure de niobium et le deuxième matériau est le nitrure de titane ;
- Le couple dans lequel le premier matériau est le de nitrure de niobium et le deuxième matériau est le titanure de niobium.
- Le couple dans lequel le premier matériau est le niobium-étain et le deuxième matériau est le nitrure de titane.

4. Dispositif électronique (DI) selon la revendication 1 ou la revendication 3 dans sa dépendance à la revendication 1 dans lequel le dispositif (DI) comprend une pluralité de niveaux de routage (NR1,NR2) reliés entre eux par des vias, la piste conductrice (PC) étant formée sur une partie au moins de ces niveaux de routages (NR1,NR2) et le matériau utilisé pour les sections (SE) d'un niveau de routage donné étant différent du matériau utilisé pour les sections (SE) du niveau de routage immédiatement au-dessus et au-dessous, chaque via étant fait dans l'un des matériaux du niveau de routage (NR1,NR2) parmi les deux niveaux de routage (NR1,NR2) qu'il relie.

5. Dispositif électronique (DI) selon la revendication 1 ou la revendication 3 dans sa dépendance à la revendication 1 dans lequel le dispositif (DI) comprend une pluralité de niveaux de routage (NR1,NR2), les niveaux de routage (NR1,NR2) étant connectés entre eux par des vias, la piste conductrice (PC) étant formée sur une partie au moins de ces niveaux de routages (NR1,NR2), la pluralité de premières sections (SE1) étant formée dans une partie au moins des niveaux de routage de la pluralité de niveaux de routage, chaque deuxième section (SE2) formant un via reliant une première section (SE1) de la pluralité de premières sections (SE1) d'un niveau de routage (NR1) à une première section (SE1) de la pluralité de premières sections (SE1) d'un niveau de routage (NR2) situé au-dessus ou au-dessous.

6. Dispositif électronique (DI) selon la revendication précédente, dans lequel le dispositif (DI) comporte une alternance de deux types de couche : une première couche (CM) d'un premier matériau diélectrique (CM) ayant un premier module de Young, dite couche molle (CM), et une deuxième couche d'un deuxième matériau diélectrique (CD) ayant un deuxième module de Young supérieur au premier module de Young, dite couche dure (CD), chaque niveau de routages (NR1, NR2) étant réalisée dans une couche dure (CD) et chaque via (VI) étant réalisé, au moins en partie, dans une couche molle (CM).

7. Dispositif électronique (DI) selon la revendication précédente dans lequel le premier matériau diélectrique est le SiO₂ (CM) et le deuxième matériau diélectrique est le SiN (CD).

8. Dispositif électronique (DI) selon l'une des deux revendications précédentes dans lequel l'extrémité de chaque via (VI) s'étend dans une couche dure (CD) de sorte que l'interface entre chaque via et les deux niveaux de routage (NR1, NR2) qu'il relie est formée dans une couche dure (CD).

9. Dispositif électronique (DI) selon la revendication 6 ou la revendication 7 dans lequel chaque via (VI) est réalisé entièrement dans une couche molle (CM) et s'étend sur toute l'épaisseur de ladite couche molle (CM).

10. Dispositif électronique (DI) selon l'une des revendications précédentes dans lequel les matériaux supraconducteurs ont une température critique supérieure à 2K, de préférence supérieure à 4K.

11. Dispositif électronique (DI) selon l'une des revendications précédentes dans lequel les matériaux formant les interfaces de désadaptation acoustique (IA) sont choisis de sorte que le ratio de la vitesse du son transversale mesurée à 90% de la température critique du matériau ayant la température critique la plus faible dans les matériaux respectifs est supérieur à 1.5.

12. Dispositif électronique (DI) selon l'une des revendications précédentes dans lequel chaque piste conductrice comprend au moins 100 interfaces de désadaptation acoustique (IA).

13. Système comprenant un dispositif (DI) selon l'une des revendications précédentes, un premier composant électronique (CE1) et un deuxième composant électronique (CE2), le premier composant électronique (CE1) et le deuxième composant électronique (CE2) étant disposés sur la première surface (S1) du dispositif (DI) et connectés électriquement l'un à l'autre au moyen de la piste conductrice (PC) du dispositif (DI).

14. Procédé (100) de fabrication d'un dispositif électronique (DI) à partir d'un substrat (SB), le procédé comprenant :
- une première étape (1E1) de dépôt d'une couche (SC1) d'un premier matériau supraconducteur sur le substrat (SB) ;
- une première étape (1E2) de lithographie de la couche (SC1) de premier matériau supraconducteur de sorte à définir des motifs sur ladite couche ;
- une première étape (1E3) de gravure des motifs définis lors de la première étape (1E2) de lithographie sur toute l'épaisseur de la couche (SC1) de premier matériau supraconducteur ;
- une deuxième étape (1E4) de dépôt d'une couche (SC2) d'un deuxième matériau supraconducteur sur la couche (SE1) de premier matériau supraconducteur et dans les motifs gravés lors de la première étape (1E3) de gravure ;
- une deuxième étape (1E5) de lithographie de la couche (SC2) de deuxième matériau supraconducteur de sorte à définir des motifs sur la partie de la couche (SC2) de deuxième matériau supraconducteur située sur la couche (SE1) de premier matériau supraconducteur ;
- une deuxième étape (1E6) de gravure des motifs définis lors de la deuxième étape (1E5) de lithographie sur tout l'épaisseur de la couche (SC2) de deuxième matériau supraconducteur de sorte à définir une pluralité de sections (SE1, SE2) disposées les unes à la suite des autres pour former au moins une piste conductrice (PC), deux sections (SE1, SE2) successives étant dans un matériau supraconducteur différent et choisi parmi le premier matériau supraconducteur et le deuxième matériau supraconducteur de sorte à former une interface de désadaptation acoustique (IA) entre chaque section.

15. Procédé (100) selon la revendication précédente comprenant en outre, après la deuxième étape (1E6) de gravure, une étape (1E8) de dépôt d'une couche d'encapsulation.

16. Procédé selon l'une des deux revendications précédentes comprenant en outre, après la deuxième étape (1E6) de gravure et avant l'étape (1E8) de dépôt d'une couche d'encapsulation si cette étape est mise en oeuvre, une étape (1E7) de polissage mécano-chimique.

17. Procédé (200) de fabrication d'un dispositif électronique (DI) à partir d'un substrat (SB), le procédé (200) comprenant :
- une première étape (2E1) de dépôt d'une couche (CS1) d'un premier matériau supraconducteur sur le substrat (SB) ;
- une première étape (2E2) de lithographie de la couche (SC1) de premier matériau supraconducteur de sorte à définir des motifs sur ladite couche (SC1) ;
- une première étape (2E3) de gravure des motifs définis lors de la première étape de lithographie sur toute l'épaisseur de la couche (SC1) de premier matériau supraconducteur ;
- une deuxième étape (2E4) de dépôt d'une couche (PA) de passivation sur la couche (SE1) de premier matériau supraconducteur et sur le substrat (SB) encore exposé ;
- une deuxième étape (2E5) de lithographie de la couche (PA) de passivation de sorte à définir des motifs sur ladite couche (PA) au-dessus de la couche (SE1) de premier matériau supraconducteur ;
- une deuxième étape (2E6) de gravure des motifs définis lors de la deuxième étape (2E5) de lithographie sur toute l'épaisseur de la couche (PA) de passivation de sorte à exposer une partie de la couche (SE1) d'un premier matériau supraconducteur ;
- une troisième étape (2E7) de dépôt d'une couche (SC2) d'un deuxième matériau supraconducteur différent du premier matériau supraconducteur sur la couche (PA) de passivation et dans les motifs gravés lors de la deuxième étape (2E6) de gravure ;
- une étape (2E8) de polissage mécano-chimique de sorte à ne conserver que la couche (SE2) d'un deuxième matériau conducteur déposée dans les motifs gravés précédemment et ainsi former des vias (VI) dans le deuxième matériau supraconducteur ;
- une quatrième étape (2E9) de dépôt d'une couche (SC1) du premier matériau supraconducteur ;
- une troisième étape (2E10) de lithographie de la couche (SC1) de premier matériau supraconducteur de sorte à définir des motifs sur ladite couche (SC1) ;
- une troisième étape (2E11) de gravure des motifs définis lors de la troisième étape (2E10) de lithographie sur toute l'épaisseur de la couche de premier matériau supraconducteur ;
procédé (200) dans lequel le premier matériau supraconducteur et le deuxième matériau supraconducteur sont choisis de sorte à former, lorsqu'ils sont en contact l'un de l'autre, une interface de désadaptation acoustique (IA).

18. Procédé selon la revendication précédente dans lequel les première, deuxième et troisième étapes (2E1, 2E4, 2E7) de dépôt, les premières et deuxièmes étapes (2E2, 2E5) de lithographie, les première et deuxième étapes (2E3, 2E6) de gravure et l'étape (2E8) de polissage mécano chimique sont répétées une pluralité de fois de sorte à obtenir une pluralité de niveaux de routage (NR1, NR2) dans le premier matériau supraconducteur connectés entre eux par des vias (VI) dans le deuxième matériau supraconducteur.

19. Procédé (300) de fabrication d'un dispositif (DI) à partir d'un substrat (SB) comprenant une première couche d'un matériau diélectrique ayant un premier module de Young, dite couche molle (CM), le procédé comprenant :
- une première étape (3E1) de dépôt d'une deuxième couche (CD) d'un deuxième matériau diélectrique, dite couche dure (CD), ayant un deuxième module de Young supérieur au premier module de Young ;
- une deuxième étape (3E2) de dépôt d'une couche (SC1) d'un premier matériau supraconducteur sur la couche (CD) dure déposée lors de la première étape (3E1) de dépôt ;
- une première étape (3E3) de lithographie de sorte à définir les motifs d'une ou plusieurs sections (SE1) d'une piste conductrice (PC) dans la couche (SC1) de premier matériau supraconducteur ;
- une première étape (3E4) de gravure de la couche (SC1) d'un premier matériau supraconducteur sur toute son épaisseur selon les motifs définis lors de la première étape (3E3) de lithographie ;
- une troisième étape (3E5) de dépôt d'une couche (CD) du deuxième matériau diélectrique de sorte à recouvrir les sections obtenue à l'issue de la première étape (3E4) de gravure ;
- une première étape (3E6) de polissage mécano-chimique de la couche (CD) du deuxième matériau diélectrique déposée lors de la troisième étape (3E5) de dépôt ;
- une quatrième étape (3E7) de dépôt d'une couche (CM) de premier matériau diélectrique sur la couche (CD) de deuxième matériau diélectrique ;
- une cinquième étape (3E8) de dépôt d'une couche (CD) de deuxième matériau diélectrique sur la couche (CM) de premier matériau diélectrique ;
- une deuxième étape (3E9) de lithographie de sorte à définir les motifs d'une ou plusieurs sections (SE2) de la piste conductrice (PC) destinées à former les vias (VI) de la piste conductrice (PC) ;
- une deuxième étape (3E10) de gravure selon les motifs défini lors de la deuxième étape de lithographie (3E9) jusqu'à découvrir les parties de la couche de matériau supraconducteur (SE1) situées sous les motifs ;
- une sixième étape (3E11) de dépôt d'une couche d'un deuxième matériau supraconducteur (SC2) selon une épaisseur suffisante pour combler les motifs gravés lors de la deuxième étape (3E10) de gravure ;
- une deuxième étape (3E12) de polissage mécano-chimique de sorte à retirer le deuxième matériau supraconducteur en dehors des motifs définis lors de la deuxième étape (3E9) de lithographie et ainsi à dégager la couche (CD) de deuxième matériau diélectrique déposée lors de la cinquième étape de dépôt (3E8) ;
- une septième étape (3E13) de dépôt d'une couche du premier matériau supraconducteur sur la structure issue de l'étape (3E12) précédente ;
- une troisième étape (3E14) de lithographie de sorte à définir les motifs d'une ou plusieurs sections (SE1) de la piste conductrice PC ;
- une troisième étape (3E15) de gravure de la couche (SC1) du premier matériau sur toute son épaisseur selon les motifs définis lors de la troisième étape de (3E14) lithographie ;
- une huitième étape (3E16) de dépôt d'une couche (CD) du deuxième matériau diélectrique ;
- une troisième étape (3E17) de polissage mécano-chimique de la couche (CD) du deuxième matériau diélectrique déposée lors de la huitième étape (3E16) de dépôt ;
- une neuvième étape (3E18) de dépôt d'une couche (CM) du premier matériau diélectrique
procédé (300) dans lequel le premier matériau supraconducteur et le deuxième matériau supraconducteur sont choisis de sorte à former, lorsqu'ils sont en contact l'un de l'autre, une interface de désadaptation acoustique (IA).

## Patentansprüche

1. Elektronische Vorrichtung (DI) mit einer ersten Oberfläche (S1) und einer zweiten Oberfläche (S2), die der ersten Oberfläche (S1) gegenüberliegt, und zum Verbinden einer ersten elektronischen Komponente (CE1) mit einer zweiten elektronischen Komponente (CE2) bestimmt ist, die sich auf der ersten Oberfläche (S1) befinden, mittels mindestens einer Leiterbahn (PC), wobei die Leiterbahn (PC) mehrere erste Abschnitte (SE1) aus einem ersten supraleitenden Material und mehrere zweite Abschnitte (SE2) aus einem zweiten supraleitenden Material, das sich vom ersten supraleitenden Material unterscheidet, umfasst, wobei die Leiterbahn (PC) durch abwechselnde erste Abschnitte (SE1) und zweite Abschnitte (SE2) gebildet wird, wobei das erste Material und das zweite Material so gewählt sind, dass jeder Abschnitt (SE1/SE2) mit dem ihm folgenden Abschnitt (SE2/SE1), falls ein solcher Abschnitt (SE2/SE1) existiert, und dem ihm vorausgehenden Abschnitt (SE2/SE1), falls ein solcher Abschnitt (SE2/SE1) existiert, eine akustische Fehlanpassungsschnittstelle (IA) bildet.

2. Vorrichtung (DI) nach Anspruch 1, wobei die Vorrichtung (DI) abwechselnd zwei Arten von Schichten aufweist: eine erste Schicht aus einem ersten dielektrischen Material mit einem ersten Elastizitätsmodul, die sogenannte weiche Schicht (CM), und eine zweite Schicht (CD) aus einem zweiten dielektrischen Material mit einem zweiten Elastizitätsmodul, das größer ist als das erste Elastizitätsmodul, die sogenannte harte Schicht (CD), wobei die Leiterbahn (PC) in einer der weichen Schichten (CM) ausgebildet ist.

3. Elektronische Vorrichtung (DI) nach Anspruch 1 oder dem vorhergehenden Anspruch 2, bei der das Paar, das durch das erste supraleitende Material und das zweite supraleitende Material gebildet wird, aus den folgenden Paaren ausgewählt wird:
- Paar, bei dem das erste Material Niob und das zweite Material Titannitrid ist;
- Paar, bei dem das erste Material Niobnitrid und das zweite Material Titannitrid ist;
- Paar, bei dem das erste Material Niobnitrid ist und das zweite Material Niobtitanid ist.
- Paar, bei dem das erste Material Niob-Zinn und das zweite Material Titannitrid ist.

4. Elektronische Vorrichtung (DI) nach Anspruch 1 oder Anspruch 3 in Abhängigkeit von Anspruch 1, wobei die Vorrichtung (DI) eine Vielzahl von Routing-Ebenen (NR1, NR2) umfasst, die durch Lücken miteinander verbunden sind, wobei die Leiterbahn (PC) auf mindestens einem Teil dieser Routing-Ebenen (NR1,NR2) und das für die Abschnitte (SE) einer bestimmten Routing-Ebene verwendete Material sich von dem Material unterscheidet, das für die Abschnitte (SE) der unmittelbar darüber und darunter liegenden Routing-Ebene verwendet wird, wobei jede Lücke aus einem der Materialien der Routing-Ebene (NR1, NR2) unter den beiden Routing-Ebenen (NR1, NR2), die sie verbindet, hergestellt ist.

5. Elektronische Vorrichtung (DI) nach Anspruch 1 oder Anspruch 3 in Abhängigkeit von Anspruch 1, wobei die Vorrichtung (DI) eine Vielzahl von Routing-Ebenen (NR1, NR2) umfasst, wobei die Routing-Ebenen (NR1, NR2) durch Lücken miteinander verbunden sind, wobei die Leiterbahn (PC) auf mindestens einem Teil dieser Routing-Ebenen (NR1, NR2) ausgebildet ist, die Vielzahl von ersten Abschnitten (SE1) in mindestens einem Teil der Routing-Ebenen der Vielzahl von Routing-Ebenen ausgebildet ist, wobei jeder zweite Abschnitt (SE2) eine Lücke bildet, die einen ersten Abschnitt (SE1) der Vielzahl von ersten Abschnitten (SE1) einer Routing-Ebene (NR1) mit einem ersten Abschnitt (SE1) der Vielzahl von ersten Abschnitten (SE1) einer darüber oder darunter liegenden Routing-Ebene (NR2) verbindet.

6. Elektronische Vorrichtung (DI) nach dem vorhergehenden Anspruch, wobei die Vorrichtung (DI) eine Abwechslung von zwei Schichttypen aufweist: eine erste Schicht (CM) aus einem ersten dielektrischen Material (CM) mit einem ersten Elastizitätsmodul, die sogenannte weiche Schicht (CM), und eine zweite Schicht aus einem zweiten dielektrischen Material (CD) mit einem zweiten Elastizitätsmodul, das größer ist als das erste Elastizitätsmodul, die sogenannte harte Schicht (CD), wobei jede Routing-Ebene (NR1, NR2) in einer harten Schicht (CD) realisiert ist und jede Lücke (VI) zumindest teilweise in einer weichen Schicht (CM) realisiert ist.

7. Elektronische Vorrichtung (DI) nach dem vorhergehenden Anspruch, wobei das erste dielektrische Material SiO₂ (CM) und das zweite dielektrische Material SiN (CD) ist.

8. Elektronische Vorrichtung (DI) nach einem der beiden vorhergehenden Ansprüche, bei der sich das Ende jeder Lücke (VI) in eine harte Schicht (CD) erstreckt, so dass die Schnittstelle zwischen jeder Lücke und den beiden Routing-Ebenen (NR1, NR2), die sie verbindet, in einer harten Schicht (CD) ausgebildet ist.

9. Elektronische Vorrichtung (DI) nach Anspruch 6 oder Anspruch 7, wobei jede Lücke (VI) vollständig in einer weichen Schicht (CM) hergestellt ist und sich über die gesamte Dicke der weichen Schicht (CM) erstreckt.

10. Elektronische Vorrichtung (DI) nach einem der vorhergehenden Ansprüche, bei der die supraleitenden Materialien eine kritische Temperatur von mehr als 2K, vorzugsweise mehr als 4K, aufweisen.

11. Elektronische Vorrichtung (DI) nach einem der vorhergehenden Ansprüche, bei der die Materialien, die die akustischen Fehlanpassungsschnittstellen (IA) bilden, so ausgewählt sind, dass das Verhältnis der transversalen Schallgeschwindigkeit, die bei 90% der kritischen Temperatur des Materials mit der niedrigsten kritischen Temperatur in den jeweiligen Materialien gemessen wird, größer als 1,5 ist.

12. Elektronische Vorrichtung (DI) nach einem der vorhergehenden Ansprüche, in der jede Leiterbahn mindestens 100 Fehlanpassungsschnittstellen (IA) umfasst.

13. System mit einer Vorrichtung (DI) nach einem der vorhergehenden Ansprüche, einem ersten elektronischen Bauteil (CE1) und einem zweiten elektronischen Bauteil (CE2), wobei das erste elektronische Bauteil (CE1) und das zweite elektronische Bauteil (CE2) auf der ersten Oberfläche (S1) der Vorrichtung (DI) angeordnet sind und mittels der Leiterbahn (PC) der Vorrichtung (DI) elektrisch miteinander verbunden sind.

14. Verfahren (100) zur Herstellung einer elektronischen Vorrichtung (DI) ausgehend von einem Substrat (SB), wobei das Verfahren umfasst:
- einen ersten Schritt (1E1) zum Aufbringen einer Schicht (SC1) aus einem ersten supraleitenden Material auf das Substrat (SB);
- einen ersten Schritt (1E2) des Lithografierens der Schicht (SC1) aus dem ersten supraleitenden Material, um so Muster auf dieser Schicht zu definieren;
- einen ersten Schritt (1E3) des Ätzens der im ersten Schritt (1E2) des Lithografierens definierten Muster über die gesamte Dicke der Schicht (SC1) aus dem erstem supraleitendem Material;
- einen zweiten Schritt (1E4) des Aufbringens einer Schicht (SC2) aus einem zweiten supraleitenden Material auf der Schicht (SE1) aus dem ersten supraleitenden Material und in den im ersten Schritt (1E3) des Ätzens geätzten Mustern;
- einen zweiten Schritt (1E5) des Lithografierens der Schicht (SC2) aus dem zweiten supraleitenden Material, um so Muster auf dem Teil der Schicht (SC2) aus dem zweiten supraleitendem Material zu definieren, die sich auf der Schicht (SE1) aus dem ersten supraleitenden Material befindet;
- einen zweiten Schritt (1E6) des Ätzens der im zweiten Schritt (1E5) des Lithografierens definierten Muster über die gesamte Dicke der Schicht (SC2) aus dem zweiten supraleitenden Material, um eine Vielzahl von Abschnitten (SE1, SE2) zu definieren, die nacheinander angeordnet sind, um mindestens eine Leiterbahn (PC) zu bilden, wobei zwei aufeinanderfolgende Abschnitte (SE1, SE2) aus einem unterschiedlichen supraleitenden Material bestehen und aus dem ersten supraleitenden Material und dem zweiten supraleitenden Material ausgewählt sind, so dass eine akustische Fehlanpassungsschnittstelle (IA) zwischen jedem der Abschnitte gebildet wird.

15. Verfahren (100) nach dem vorhergehenden Anspruch, das nach dem zweiten Schritt (1E6) des Ätzens außerdem einen Schritt (1E8) des Auftragens einer Verkapselungsschicht umfasst.

16. Verfahren nach einem der beiden vorhergehenden Ansprüche, das außerdem nach dem zweiten Schritt (1E6) des Ätzens und vor dem Schritt (1E8) des Auftragens einer Verkapselungsschicht, falls dieser Schritt durchgeführt wird, einen Schritt (1E7) des chemisch-mechanischen Polierens umfasst.

17. Verfahren (200) zur Herstellung einer elektronischen Vorrichtung (DI) ausgehend von einem Substrat (SB), wobei das Verfahren (200) Folgendes umfasst:
- einen ersten Schritt (2E1) zum Aufbringen einer Schicht (CS1) aus einem ersten supraleitenden Material auf das Substrat (SB);
- einen ersten Schritt (2E2) des Lithografierens der Schicht (SC1) aus dem ersten supraleitenden Material, um so Muster auf der Schicht (SC1) zu definieren;
- einen ersten Schritt (2E3) des Ätzens der im ersten Schritt des Lithografierens definierten Muster über die gesamte Dicke der Schicht (SC1) aus dem erstem supraleitenden Material;
- einen zweiten Schritt (2E4) des Aufbringens einer Passivierungsschicht (PA) auf der Schicht (SE1) aus dem ersten supraleitenden Material und auf dem noch freiliegenden Substrat (SB);
- einen zweiten Schritt (2E5) des Lithografierens der Passivierungsschicht (PA), so dass Muster auf dieser Schicht (PA) über der Schicht (SE1) aus dem ersten supraleitenden Material definiert werden;
- einen zweiten Schritt (2E6) des Ätzens der im zweiten Schritt (2E5) des Lithografierens definierten Muster über die gesamte Dicke der Passivierungsschicht (PA), so dass ein Teil der Schicht (SE1) aus einem ersten supraleitenden Material freigelegt wird;
- einen dritten Schritt (2E7) des Aufbringens einer Schicht (SC2) aus einem zweiten supraleitenden Material, das sich von dem ersten supraleitenden Material unterscheidet, auf der Passivierungsschicht (PA) und in den im zweiten Schritt (2E6) des Ätzens geätzten Mustern;
- einen Schritt (2E8) des chemisch-mechanischen Polierens, um nur die Schicht (SE2) aus einem zweiten leitfähigen Material zu bewahren, die in den zuvor geätzten Mustern abgelagert ist, und so Lücken (VI) in dem zweiten supraleitenden Material zu bilden;
- einen vierten Schritt (2E9) des Aufbringens einer Schicht (SC1) des ersten supraleitenden Materials;
- einen dritten Schritt (2E10) des Lithografierens der Schicht (SC1) aus dem ersten supraleitenden Material, um so Muster auf der Schicht (SC1) zu definieren;
- einen dritten Schritt (2E11) des Ätzens der im dritten Schritt (2E10) des Lithografierens definierten Muster über die gesamte Dicke der Schicht aus dem ersten supraleitenden Material;
Verfahren (200), bei dem das erste supraleitende Material und das zweite supraleitende Material so ausgewählt werden, dass sie, wenn sie miteinander in Kontakt sind, eine akustische Fehlanpassungsschnittstelle (IA) bilden.

18. Verfahren nach dem vorhergehenden Anspruch, bei dem der erste, zweite und dritte Schritt (2E1, 2E4, 2E7) des Auftragens, der erste und zweite Schritt (2E2, 2E5) des Lithografierens, der erste und zweite Schritt (2E3, 2E6) des Ätzens und der Schritt (2E8) des chemisch-mechanischen Polierens mehrfach wiederholt werden, so dass eine Vielzahl von Routing-Ebenen (NR1, NR2) im ersten supraleitenden Material erhalten wird, die durch Lücken (VI) im zweiten supraleitenden Material miteinander verbunden sind.

19. Verfahren (300) zur Herstellung einer Vorrichtung (DI) aus einem Substrat (SB), das eine erste Schicht aus einem dielektrischen Material mit einem ersten Elastizitätsmodul, eine sogenannte weiche Schicht (CM), umfasst, wobei das Verfahren umfasst:
- einen ersten Schritt (3E1) des Aufbringens einer zweiten Schicht (CD) aus einem zweiten dielektrischen Material, der sogenannten harten Schicht (CD), mit einem zweiten Elastizitätsmodul, das größer ist als das erste Elastizitätsmodul;
- einen zweiten Schritt (3E2) des Aufbringens einer Schicht (SC1) aus einem ersten supraleitenden Material auf der harten Schicht (CD), die im ersten Schritt (3E1) des Aufbringens aufgetragen wurde;
- einen ersten Schritt (3E3) des Lithografierens, um die Muster eines oder mehrerer Abschnitte (SE1) einer Leiterbahn (PC) in der Schicht (SC1) aus dem ersten supraleitenden Material zu definieren;
- einen ersten Schritt (3E4) des Ätzens der Schicht (SC1) aus einem ersten supraleitenden Material über ihre gesamte Dicke gemäß den Mustern, die im ersten Schritt (3E3) des Lithografierens definiert wurden;
- einen dritten Schritt (3E5) des Auftragens einer Schicht (CD) des zweiten dielektrischen Materials, um so die nach dem ersten Schritt (3E4) des Ätzens erhaltenen Abschnitte zu bedecken;
- einen ersten Schritt (3E6) des chemisch-mechanischen Polierens der Schicht (CD) aus dem zweiten dielektrischen Materials, die im dritten Schritt (3E5) des Auftragens aufgetragen wird;
- einen vierten Schritt (3E7) des Auftragens einer Schicht (CM) aus einem ersten dielektrischen Material auf der Schicht (CD) aus einem zweiten dielektrischen Material;
- einen fünften Schritt (3E8) des Auftragens einer Schicht (CD) aus einem zweiten dielektrischen Material auf der Schicht (CM) aus einem ersten dielektrischen Material;
- einen zweiten Schritt (3E9) des Lithografierens, um so die Muster eines oder mehrerer Abschnitte (SE2) der Leiterbahn (PC) zu definieren, die dazu bestimmt sind, die Lücken (VI) der Leiterbahn (PC) zu bilden;
- einen zweiten Schritt (3E10) des Ätzens gemäß den Mustern, die im zweiten Schritt des Lithografierens (3E9) definiert wurden, bis die Teile der Schicht aus supraleitendem Material (SE1), die unter den Mustern liegen, freigelegt sind;
- einen sechsten Schritt (3E1 1) des Auftragens einer Schicht aus einem zweiten supraleitenden Material (SC2) in einer Dicke, die ausreicht, um die im zweiten Schritt (3E10) des Ätzens geätzten Muster auszufüllen;
- einen zweiten Schritt (3E12) des chemisch-mechanischen Polierens, so dass das zweite supraleitende Material außerhalb der Muster, die im zweiten Schritt des Lithografierens (3E9) definiert werden, freigelegt werden und so die Schicht (CD) aus einem zweiten dielektrischen Material, die in dem fünften Auftragungsschritt (3E8) aufgetragen wurde, freizulegen;
- einen siebten Schritt (3E13) des Auftragens einer Schicht des ersten supraleitenden Materials auf der Struktur aus dem vorhergehenden Schritt (3E12);
- einen dritten Schritt (3E14) des Lithografierens, um so die Muster eines oder mehrerer Abschnitte (SE1) der Leiterbahn PC zu definieren;
- einen dritten Schritt (3E15) des Ätzens der Schicht (SC1) des ersten Materials über ihre gesamte Dicke gemäß den Mustern, die im dritten Schritt (3E14) des Lithografierens definiert wurden;
- einen achten Schritt (3E16) des Auftragens einer Schicht (CD) des zweiten dielektrischen Materials;
- einen dritten Schritt (3E17) des chemisch-mechanischen Polierens der Schicht (CD) des zweiten dielektrischen Materials, die in dem achten Schritt (3E16) des Auftragens aufgetragen wurde;
- einen neunten Schritt (3E18) des Auftragens einer Schicht (CM) des ersten dielektrischen Materials
Verfahren (300), bei dem das erste supraleitende Material und das zweite supraleitende Material so gewählt sind, dass sie bei Kontakt miteinander eine akustische Fehlanpassungsschnittstelle (IA) bilden.

## Claims

1. Electronic device (DI) comprising a first surface (S1) and a second surface (S2) opposite to the first surface (S1) and intended to connect a first electronic component (CE1) to a second electronic component (CE2) located on the first surface (S1) by means of at least one conductor track (PC), the conductor track (PC) comprising a plurality of first sections (SE1) in a first superconducting material and a plurality of second sections (SE2) in a second superconducting material different from the first superconducting material, the conductor track (PC) being formed by an alternating of first sections (SE1) and of second sections (SE2), the first material and the second material being chosen in such a way that each section (SE1/SE2) forms with the section (SE2/SE1) that follows it, if such a section (SE2/SE1) exists, and the section (SE2/SE1) that precedes it, if such a section (SE2/SE1) exists, an acoustic mismatching interface (IA).

2. Device (DI) according to claim 1, wherein the device (DI) comprises an alternating of two types of layers: a first layer of a first dielectric material having a first Young's modulus, referred to as soft layer (CM), and a second layer (CD) of a second dielectric material having a second Young's modulus greater than the first Young's modulus, referred to as hard layer (CD), the conductor track (PC) being formed in one of the soft layers (CM).

3. Electronic device (DI) according to claim 1 or claim 2 wherein the pair formed by the first superconducting material and the second superconducting material is chosen from among the following pairs:
- The pair wherein the first material is niobium and the second material is titanium nitride;
- The pair wherein the first material is niobium nitride and the second material is titanium nitride;
- The pair wherein the first material is niobium nitride and the second material is niobium titanide;
- The pair wherein the first material is niobium-tin and the second material is titanium nitride.

4. Electronic device (DI) according to claim 1 or claim 3 in its dependency on claim 1 wherein the device (DI) comprises a plurality of routing levels (NR1, NR2) connected together by vias, the conductor track (PC) being formed on a portion at least of these routing levels (NR1, NR2) and the material used for the sections (SE) of a given routing level being different from the material used for the sections (SE) of the routing level immediately above and below, each via being made of one of the materials of the routing level (NR1, NR2) among the two routing levels (NR1, NR2) that it connects.

5. Electronic device (DI) according to claim 1 or claim 3 in its dependency on claim 1 wherein the device (DI) comprises a plurality of routing levels (NR1, NR2), the routing levels (NR1, NR2) being connected together by vias, the conductor track (PC) being formed on a portion at least of these routing levels (NR1, NR2), the plurality of first sections (SE1) being formed in a portion at least of the routing levels of the plurality of routing levels, each second section (SE2) forming a via that connects a first section (SE1) of the plurality of first sections (SE1) of a routing level (NR1) to a first section (SE1) of the plurality of first sections (SE1) of a routing level (NR2) located above or below.

6. Electronic device (DI) according to the preceding claim, wherein the device (DI) comprises an alternating of two layer types: a first layer (CM) of a first dielectric material (CM) having a first Young's modulus, referred to as soft layer (CM), and a second layer of a second dielectric material (CD) having a second Young's modulus greater than the first Young's modulus, referred to as hard layer (CD), each routing level (NR1, NR2) being carried out in a hard layer (CD) and each via (VI) being carried out, at least in part, in a soft layer (CM).

7. Electronic device (DI) according to the preceding claim wherein the first dielectric material is SiO₂ (CM) and the second dielectric material is SiN (CD).

8. Electronic device (DI) according to one of the two preceding claims wherein the end of each via (VI) extends in a hard layer (CD) in such a way that the interface between each via and the two routing levels (NR1, NR2) that it connects is formed in a hard layer (CD).

9. Electronic device (DI) according to claim 6 or claim 7 wherein each via (VI) is carried out entirely in a soft layer (CM) and extends over the entire thickness of said soft layer (CM).

10. Electronic device (DI) according to one of the preceding claims wherein the superconducting materials have a critical temperature greater than 2K, preferably greater than 4K.

11. Electronic device (DI) according to one of the preceding claims wherein the materials forming the acoustic mismatching interfaces (IA) are chosen in such a way that the ratio of the transversal speed of sound measured at 90% of the critical temperature of the material having the lowest critical temperature in the respective materials is greater than 1.5.

12. Electronic device (DI) according to one of the preceding claims wherein each conductor track comprises at least 100 acoustic mismatching interfaces (IA).

13. System comprising a device (DI) according to one of the preceding claims, a first electronic component (CE1) and a second electronic component (CE2), the first electronic component (CE1) and the second electronic component (CE2) being disposed on the first surface (S1) of the device (DI) and electrically connected to one another by means of the conductor track (PC) of the device (DI).

14. Method (100) for manufacturing an electronic device (DI) from a substrate (SB), the method comprising:
- a first step (1E1) of depositing a layer (SC1) of a first superconducting material on the substrate (SB);
- a first step (1E2) of lithography of the layer (SC1) of first superconducting material in such a way as to define patterns on said layer;
- a first step (1E3) of etching patterns defined during the first step (1E2) of lithography over the entire thickness of the layer (SC1) of first superconducting material;
- a second step (1E4) of depositing a layer (SC2) of a second superconducting material on the layer (SE1) of first superconducting material and in the patterns etched during the first step (1E3) of etching;
- a second step (1E5) of lithography of the layer (SC2) of second superconducting material in such a way as to define patterns on the portion of the layer (SC2) of second superconducting material located on the layer (SE1) of first superconducting material;
- a second step (1E6) of etching patterns defined during the second step (1E5) of lithography over the entire thickness of the layer (SC2) of second superconducting material in such a way as to define a plurality of sections (SE1, SE2) disposed one after the other in order to form at least one conductor track (PC), two successive sections (SE1, SE2) being made from a different superconducting material and chosen from among the first superconducting material and the second superconducting material in such a way as to form an acoustic mismatching interface (IA) between each section.

15. Method (100) according to the preceding claim further comprising, after the second step (1E6) of etching, a step (1E8) of depositing an encapsulation layer.

16. Method according to one of the two preceding claims further comprising, after the second step (1E6) of etching and before the step (1E8) of depositing an encapsulation layer if this step is implemented, a step (1E7) of mechanical-chemical polishing.

17. Method (200) for manufacturing an electronic device (DI) from a substrate (SB), the method (200) comprising:
- a first step (2E1) of depositing a layer (CS1) of a first superconducting material on the substrate (SB);
- a first step (2E2) of lithography of the layer (SC1) of first superconducting material in such a way as to define patterns on said layer (SC1);
- a first step (2E3) of etching patterns defined during the first step of lithography over the entire thickness of the layer (SC1) of first superconducting material;
- a second step (2E4) of depositing a passivation layer (PA) on the layer (SE1) of first superconducting material and on the substrate (SB) that is still exposed;
- a second step (2E5) of lithography of the passivation layer (PA) in such a way as to define patterns on said layer (PA) above the layer (SE1) of first superconducting material;
- a second step (2E6) of etching patterns defined during the second step (2E5) of lithography over the entire thickness of the passivation layer (PA) in such a way as to expose a portion of the layer (SE1) of a first superconducting material;
- a third step (2E7) of depositing a layer (SC2) of a second superconducting material different from the first superconducting material on the passivation layer (PA) and in the patterns etched during the second step (2E6) of etching;
- a step (2E8) of mechanical-chemical polishing in such a way as to retain only the layer (SE2) of a second conducting material deposited in the previously etched patterns and thus form vias (VI) in the second superconducting material;
- a fourth step (2E9) of depositing a layer (SC1) of the first superconducting material;
- a third step (2E10) of lithography of the layer (SC1) of first superconducting material in such a way as to define patterns on said layer (SC1);
- a third step (2E11) of etching patterns defined during the third step (2E10) of lithography over the entire thickness of the layer of first superconducting material;
method (200) wherein the first superconducting material and the second superconducting material are chosen in such a way as to form, when they are in contact with one another, an acoustic mismatching interface (IA).

18. Method according to the preceding claim wherein the first, second and third steps (2E1, 2E4, 2E7) of depositing, the first and second steps (2E2, 2E5) of lithography, the first and second steps (2E3, 2E6) of etching and the step (2E8) of mechanical-chemical polishing are repeated a plurality of times in such a way as to obtain a plurality of routing levels (NR1, NR2) in the first superconducting material connected together by vias (VI) in the second superconducting material.

19. Method (300) for manufacturing a device (DI) from a substrate (SB) comprising a first layer of a dielectric material before a first Young's modulus, referred to as soft layer (CM), the method comprising:
- a first step (3E1) of depositing a second layer (CD) of a second dielectric material, referred to as hard layer (CD), having a second Young's modulus greater than the first Young's modulus;
- a second step (3E2) of depositing a layer (SC1) of a first superconducting material on the hard layer (CD) deposited during the first step (3E1) of depositing;
- a first step (3E3) of lithography in such a way as to define the patterns of one or more sections (SE1) of a conductor track (PC) in the layer (SC1) of first superconducting material;
- a first step (3E4) of etching the layer (SC1) of a first superconducting material over the entire thickness thereof according to the patterns defined during the first step (3E3) of lithography;
- a third step (3E5) of depositing a layer (CD) of the second dielectric material in such a way as to cover the sections obtained at the end of the first step (3E4) of etching;
- a first step (3E6) of mechanical-chemical polishing of the layer (CD) of the second dielectric material deposited during the third step (3E5) of depositing;
- a fourth step (3E7) of depositing a layer (CM) of first dielectric material on the layer (CD) of second dielectric material;
- a fifth step (3E8) of depositing a layer (CD) of second dielectric material on the layer (CM) of first dielectric material;
- a second step (3E9) of lithography in such a way as to define the patterns of one or more sections (SE2) of the conductor track (PC) intended to form the vias (VI) of the conductor track (PC);
- a second step (3E10) of etching according to the patterns defined during the second step of lithography (3E9) until exposing the portions of the layer of superconducting material (SE1) located under the patterns;
- a sixth step (3E1 1) of depositing a layer of a second superconducting material (SC2) according to a thickness that is sufficient to fill in the patterns etched during the second step (3E10) of etching;
- a second step (3E12) of mechanical-chemical polishing in such a way as to remove the second superconducting material outside of the patterns defined during the second step (3E9) of lithography and as such clear the layer (CD) of second dielectric material deposited during the fifth step of depositing (3E8);
- a seventh step (3E13) of depositing a layer of the first superconducting material on the structure coming from the preceding step (3E12);
- a third step (3E14) of lithography in such a way as to define the patterns of one or more sections (SE1) of the conductor track PC;
- a third step (3E15) of etching the layer (SC1) of the first material over the entire thickness thereof according to the patterns defined during the third step of (3E14) lithography;
- an eighth step (3E16) of depositing a layer (CD) of the second dielectric material;
- a third step (3E17) of mechanical-chemical polishing of the layer (CD) of the second dielectric material deposited during the eighth step (3E16) of depositing;
- a ninth step (3E18) of depositing a layer (CM) of the first dielectric material
method (300) wherein the first superconducting material and the second superconducting material are chosen in such a way as to form, when they are in contact with one another, an acoustic mismatching interface (IA).
